# FASCICULE DE BREVET EUROPEEN

(11) **EP 4 345 821 B1**
(45) Date de publication et mention de la délivrance du brevet: **30.04.2025**
(21) Numéro de dépôt: 23198609.2
(22) Date de dépôt: 20.09.2023
(51) Int. Cl.: G11C 11/22, G11C 13/00

(54) **CIRCUIT DE TRAITEMENT LOGIQUE DE DONNEES INTEGRE DANS UN CIRCUIT DE STOCKAGE DE DONNEES**
IN EINE DATENSPEICHERSCHALTUNG INTEGRIERTE LOGISCHE DATENVERARBEITUNGSSCHALTUNG
LOGIC DATA PROCESSING CIRCUIT INTEGRATED IN A DATA STORAGE CIRCUIT

(30) Priorité: 30.09.2022 FR 2209986
(43) Date de publication de la demande: 03.04.2024
(73) Titulaire: Commissariat à l'Energie Atomique et aux Energies Alternatives, 75015 Paris (FR)
(72) Inventeur: BILLOINT, Olivier, 38054 GRENOBLE Cedex 09 (FR); GRENOUILLET, Laurent, 38054 GRENOBLE Cedex 09 (FR)
(74) Mandataire: Atout PI Laplace

(56) Documents cités:
- US-A1- 2022 027 130
- HAYASHIKOSHI MASANORI ET AL: "Processing In-Memory Architecture with On-Chip Transfer Learning Function for Compensating Characteristic Variation", 2020 IEEE INTERNATIONAL MEMORY WORKSHOP (IMW), IEEE, 17 May 2020 (2020-05-17), pages 1 - 4, XP033777312, DOI: 10.1109/IMW48823.2020.9108132

## Description

### Champ d'application

L'invention concerne généralement des circuits de stockage de données à base de cellules mémoire non-volatiles. Plus particulièrement, l'invention concerne le domaine de la conception de circuits de mémoire calculatoire ou circuit de calcul dans la mémoire (traduite du terme anglais In-Memory Computing). L'invention concerne un circuit de stockage de données permettant de réaliser des opérations logiques booléennes élémentaires au sein du circuit de stockage lui-même.

### Problème soulevé

D'une manière générale, un système sur puce comporte des circuits mémoires pour stocker les données et des circuits de calcul pour réaliser des opérations logiques et arithmétiques. Les opérations d'échange de données entre les circuits mémoires et les circuits de calcul sont très énergivores et réduisent la performance de calcul du système. Dans ce contexte, les technologies émergentes des mémoires non-volatiles permettent de réaliser des circuits de mémoire aptes à réaliser à la fois la fonction de stockage et la fonction de calcul. On parle dans ce cas de « circuit de calcul dans la mémoire ». Cela permet d'éviter les transferts de données entre les moyens de stockage et les moyens de calcul, et ainsi, permet de réduire la consommation énergétique et améliorer la vitesse de calcul.

Cependant, le développement des solutions « circuits de calcul dans la mémoire » présente plusieurs défis et contraintes tels que :
- Le recours à de larges circuits périphériques aux mémoires pour traiter les résultats. Cela augmente considérablement la surface du circuit et la complexité d'implémentation physique.
- Des contraintes au niveau de la précision des calculs réalisés. Plus particulièrement, ce problème se manifeste lors de l'exécution d'algorithmes nécessitant des calculs en parallèle.

A titre d'exemple, dans une architecture conventionnelle de type Von Neumann, jusqu'à 90% de la consommation énergétique est perdue dans le transfert entre l'unité de calcul et la mémoire.

Ainsi, il existe un besoin pour concevoir des nouvelles architectures des circuits de calcul dans la mémoire, qui soient moins complexes et présentant en même temps une réduction de la consommation électrique et une amélioration des performances calculatoires en termes de vitesse et précision.

### Art antérieur/ Restrictions de l'état de l'art

La publication scientifique intitulée «Processing In-Memory Architecture with On-Chip Transfer Learning Function for Compensating Characteristic Variation, " de M. Hayashikoshi et al présente un circuit de stockage de donnée configuré pour réaliser un traitement logique dans la matrice mémoire elle-même. La solution présentée nécessite l'ajout de plusieurs transistors supplémentaires dans chaque cellule mémoire pour relier les points mémoires entre eux selon une connexion prédéterminée. Cela présente un inconvénient consistant à l'augmentation considérable de la surface occupée par le circuit de stockage. L'augmentation de la surface engendre des couts supplémentaires de fabrication et d'intégration. Le document US 2022/027130 A1 décrit un circuit configuré pour effectuer des calculs de multiplication et d'addition de matrices, comprenant un convertisseur numérique-temporel.

### Réponse au problème et apport solution

Pour répondre aux problèmes techniques discutés ci-dessus, l'invention propose un circuit de stockage de données comprenant une matrice mémoire non-volatile et un circuit de traitement de données configuré pour lire des opérandes de ladite matrice, et réaliser des opérations logiques élémentaires à partir des données lues sans transférer les données à l'extérieur du circuit de stockage. Il est ainsi possible pour la personne du métier d'implémenter des algorithmes plus complexes à partir des fonctions logiques élémentaires dans la mémoire.

Le principe de fonctionnement du circuit de stockage de données selon l'invention est compatible avec une matrice mémoire de type ferroélectrique à polarisation électrique variable ou de type résistif à filament conducteur variable ou une matrice mémoires mixtes résistive et capacitive.

Le dispositif selon l'invention est réalisable avec un nombre de cellules mémoires considérablement supérieur à celui des solutions connues. Cela offre l'avantage de la multiplication des capacités de stockage et de calcul en même temps. Cela permet d'obtenir un dispositif compatible avec l'exécution d'algorithmes de calcul complexes au sein du circuit de stockage lui-même. De plus, le dispositif est capable de paralléliser un nombre considérable d'opérations de traitement de données pour obtenir une performance meilleure.

L'invention concerne en outre une structure en couches minces permettant de réaliser les cellules mémoires selon l'invention. Cette structure élémentaire présente l'avantage d'une compatibilité avec les techniques de fabrication de l'industrie du semiconducteur. Ainsi, le dispositif selon l'invention présente des couts de mise en production réduits.

De plus, dans le cas spécifique de mémoires de type ferroélectrique, un problème supplémentaire se présente : la lecture des données correspondant à un état logique haut (x=1) est destructive de ladite donnée. Dans ce contexte, le circuit de traitement de données selon l'invention permet de réécrire la donnée lue (x=1) dans la cellule mémoire après chaque opération de lecture de manière à réaliser une opération de lecture non-destructive. L'opération de relecture est totalement intégrée par le circuit de traitement de données selon l'invention. Il n'y a pas besoin de recopier les données dans des mémoires tampons avant la lecture, ni de transférer lesdites données vers des circuits externes. Cela permet de réduire la complexité d'implémentation du circuit de stockage. Cela permet également de réduire la consommation énergétique du circuit de stockage par limitation des échanges de données en entrée et/ou sortie du circuit de stockage.

### Résumé /Revendications

L'invention a pour objet un circuit de stockage de données comprenant :
- une matrice de cellules mémoire telle que chaque cellule mémoire comprend:
   - un composant élémentaire de stockage non volatile ayant une première électrode et une seconde électrode,
   - un premier nœud d'entrée/sortie connecté à la seconde électrode, un second nœud d'entrée/sortie , un nœud de sélection ;
   - et un transistor de sélection ayant une grille connectée au nœud de sélection et reliant la première électrode au second nœud d'entrée/sortie,
- un circuit de traitement logique configuré pour réaliser une opération logique ayant pour opérandes N données binaires stockées dans N cellules mémoires d'entrée avec N≥2; les seconds nœuds d'entrée/sortie desdites cellules mémoires d'entrée étant reliés par une ligne de bits commune ; le circuit de traitement logique comprenant :
   - un étage amplificateur à transimpédance configuré pour fournir un signal de lecture analogique à partir de la tension de la ligne de bits commune ;
   - un comparateur destiné à comparer le signal de lecture analogique à une première tension de référence ajustable pour générer un signal de sortie numérique correspondant au résultat de l'opération logique ;
   - une unité de contrôle configurée pour ajuster la tension de référence à une amplitude choisie parmi N amplitudes prédéterminées distinctes, selon le type de l'opération logique.

Selon un aspect particulier de l'invention, le circuit de stockage de données comprend en outre un séquenceur configuré pour appliquer:
- un signal de contrôle d'écriture et de lecture sur le premier nœud d'entrée/sortie de chacune des cellules mémoires d'entrée;
- un signal de sélection sur le nœud de sélection de chacune des cellules mémoires d'entrée.

Selon un aspect particulier de l'invention, les premiers nœuds d'entrée/sortie desdites cellules mémoires d'entrée sont reliés par une ligne de source commune.

Selon un aspect particulier de l'invention, l'étage amplificateur à transimpédance capacitive comprend :
- un amplificateur opérationnel ayant : une première entrée connectée au second nœud d'entrée/sortie des cellules mémoires d'entrée, et une seconde entrée pour recevoir une seconde tension de référence; et une sortie pour fournir ledit signal de lecture analogique ;
- une impédance de rétroaction montée entre la sortie et la première entrée de l'amplificateur opérationnel.

Selon un aspect particulier de l'invention, le circuit de traitement logique comprend en outre un interrupteur de réinitialisation monté entre la sortie et la première entrée de l'amplificateur opérationnel.

Selon un aspect particulier de l'invention, l'impédance de rétroaction est une impédance capacitive et dans lequel les composants élémentaires de stockage des cellules mémoires d'entrée sont de type ferroélectrique à polarisation électrique variable. Chaque cellule mémoire peut présenter un premier ou un deuxième état logique correspondant respectivement à des niveaux différents de charges stockées dans le composant élémentaire de stockage associé .

Selon un aspect particulier de l'invention, chaque composant élémentaire de stockage des cellules mémoires d'entrée présente une première capacité prédéterminée, et dans lequel l'impédance de rétroaction est un élément capacitif ayant une seconde capacité supérieure à N fois ladite première capacité prédéterminée.

Selon un aspect particulier de l'invention, les N amplitudes prédéterminées sont ordonnées selon un ordre décroissant, et le circuit de traitement logique est configuré pour réaliser une opération logique en exécutant les étapes suivantes :
i) une étape de réinitialisation pour décharger l'élément capacitif, polariser la première entrée de l'amplificateur opérationnel à la seconde tension de référence et ajuster la première tension de référence à l'amplitude maximale parmi les N amplitudes prédéterminées ;
ii) une étape de lecture d'une première cellule mémoire d'entrée en mettant à l'état passant son transistor de sélection et en appliquant un signal de contrôle de lecture sur son premier nœud d'entrée/sortie ayant une amplitude sensiblement égale à la seconde tension de référence de sorte à engendrer un transfert de charges depuis le composant élémentaire de stockage de la cellule mémoire sélectionnée vers son élément capacitif associé
iii) une étape d'ajustement de la première tension de référence par l'unité de contrôle en ajustant l'amplitude de la première tension de référence à l'amplitude d'ordre suivant parmi les N amplitudes prédéterminées lorsque la donnée binaire lue dans l'étape précédente est un état logique haut ;
iv) réitérer les étapes ii) et iii) pour les N cellules mémoires d'entrée ;
v) une étape d'ajustement de la première tension de référence à une valeur prédéterminée, selon le type de l'opération logique, parmi les N amplitudes par l'unité de contrôle pour générer un signal de sortie numérique correspondant au résultat de l'opération logique.

Selon un aspect particulier de l'invention, chaque composant élémentaire de stockage des cellules mémoires d'entrée présente une première capacité prédéterminée, et dans lequel l'impédance de rétroaction est réalisée par N éléments capacitifs montés en parallèle, chaque élément capacitif étant associé à une cellule mémoire d'entrée et ayant une seconde capacité supérieure ou égale à ladite première capacité prédéterminée.

Selon un aspect particulier de l'invention, le circuit de traitement logique est configuré pour réaliser une opération logique en exécutant les étapes suivantes :
i') une étape de réinitialisation pour décharger les éléments capacitifs, polariser la première entrée de l'amplificateur opérationnel à la seconde tension de référence et ajuster la première tension de référence à l'amplitude maximale parmi les N amplitudes prédéterminées ;
ii') une étape de lecture d'une première cellule mémoire d'entrée en mettant à l'état passant son transistor de sélection et en appliquant un signal de contrôle de lecture sur son premier nœud d'entrée/sortie ayant une amplitude sensiblement égale à la seconde tension de référence de sorte à engendrer un transfert de charges depuis le composant élémentaire de stockage de la cellule mémoire sélectionnée vers son élément capacitif associé .
iii') réitérer l'étape ii') pour les N cellules mémoires d'entrée ;
iv') une étape d'ajustement de la première tension de référence à une valeur prédéterminée, selon le type de l'opération logique, parmi les N amplitudes pour générer un signal de sortie numérique correspondant au résultat de l'opération logique.

Selon un aspect particulier de l'invention, le circuit séquenceur est configuré pour, suite à la lecture d'une donnée correspondant au second état logique dans une cellule mémoire sélectionnée, appliquer un signal de contrôle , sur le premier nœud d'entrée/sortie de ladite cellule mémoire sélectionnée, ayant une amplitude inférieure à la seconde tension de référence et maintenir le transistor de sélection de la cellule mémoire sélectionnée à un état passant de sorte à remettre, dans son composant élémentaire de stockage , un niveau de charges correspondant au second état logique .

Selon un aspect particulier de l'invention, ledit premier état logique correspond à un état non chargé d'un composant élémentaire de stockage. ledit circuit séquenceur est tel que, suite à la lecture d'une donnée correspondant à un premier état logique , ledit circuit séquenceur est configuré pour rendre non conducteur ledit transistor de sélection de la cellule mémoire sélectionnée avant de modifier le signal de contrôle sur le premier nœud d'entrée/sortie vers une nouvelle valeur, pour maintenir la cellule mémoire venant d'être lue à un état non chargé.

Selon un aspect particulier de l'invention, le composant élémentaire de stockage d'une cellule mémoire d'entrée est de type FeRAM ou de type jonction à tunnel ferroélectrique FTJ.

Selon un aspect particulier de l'invention, l'impédance de rétroaction est une impédance résistive. Les composants élémentaires de stockage des cellules mémoires d'entrée sont de type résistif à filament conducteur variable.

Selon un aspect particulier de l'invention, le circuit de traitement logique est configuré pour réaliser une opération logique en exécutant les étapes suivantes :
a) une étape de réinitialisation pour polariser la première entrée de l'amplificateur opérationnel à la seconde tension de référence et ajuster la première tension de référence à l'amplitude maximale parmi les N amplitudes prédéterminées ;
b) une étape de lecture des cellules mémoire d'entrée , en mettant à l'état passant leurs transistors de sélection parallèlement ou séquentiellement, et en appliquant un signal de contrôle de lecture positif sur leurs premiers nœuds d'entrée/sortie ;
c) une étape d'ajustement de la première tension de référence à une valeur prédéterminée, selon le type de l'opération logique, parmi les N amplitudes, par l'unité de contrôle , pour générer un signal de sortie numérique correspondant au résultat de l'opération logique.

Selon un aspect particulier de l'invention, lors de l'étape d'ajustement de la première tension de référence selon le type de l'opération logique, l'unité de contrôle est configurée pour ajuster la première tension de référence à l'amplitude minimale parmi les N amplitudes prédéterminées lorsque l'opération logique est de type ET.

Selon un aspect particulier de l'invention, lors de l'étape d'ajustement de la première tension de référence selon le type de l'opération logique, l'unité de contrôle est configurée pour ajuster la première tension de référence à l'amplitude maximale parmi les N amplitudes prédéterminées lorsque l'opération logique est de type OU.

### Brève Description des Dessins

D'autres caractéristiques et avantages de la présente invention apparaîtront mieux à la lecture de la description qui suit en relation aux dessins annexés suivants.
[Fig. 1a] illustre une vue en coupe d'un exemple d'un composant élémentaire d'une cellule mémoire ferroélectrique à polarisation électrique variable compatible avec l'invention.
[Fig. 1b] illustre une modélisation électrique d'une cellule mémoire ferroélectrique à polarisation électrique variable compatible avec l'invention.
[Fig. 2a] illustre un schéma électrique d'un premier mode de réalisation du circuit de traitement selon l'invention connecté à N=3 cellules mémoire ferroélectrique à polarisation électrique variable.
[Fig. 2b] illustre les étapes de fonctionnement du circuit de traitement selon premier mode de réalisation de l'invention pour réaliser une opération logique élémentaire.
[Fig. 2c] illustre l'ajustement de la première tension de référence du comparateur du circuit de traitement selon premier mode de réalisation de l'invention pour réaliser une opération logique de type ET à trois opérandes.
[Fig. 2d] illustre l'ajustement de la première tension de référence du comparateur du circuit de traitement selon premier mode de réalisation de l'invention pour réaliser une opération logique de type OU à trois opérandes.
[Fig. 3a] illustre un schéma électrique d'un deuxième mode de réalisation du circuit de traitement selon l'invention connecté à N=3 cellules mémoire ferroélectrique à polarisation électrique variable.
[Fig. 3b] illustre un schéma électrique d'un troisième mode de réalisation du circuit de traitement selon l'invention connecté à N=3 cellules mémoire ferroélectrique à polarisation électrique variable.
[Fig. 3c] illustre les étapes de fonctionnement du circuit de traitement selon troisième mode de réalisation de l'invention pour réaliser une opération logique élémentaire.
[Fig. 4a] illustre un schéma électrique d'un quatrième mode de réalisation du circuit de traitement selon l'invention connecté à N=3 cellules mémoire ferroélectrique à polarisation électrique variable.
[Fig. 4b] illustre les étapes de fonctionnement du circuit de traitement selon quatrième mode de réalisation de l'invention pour réaliser une opération logique élémentaire.
[Fig. 4c] illustre un organigramme des signaux de contrôle de la cellule mémoire suite à la lecture d'un état logique bas (x=0) par le circuit de traitement selon le quatrième mode de réalisation de l'invention.
[Fig. 4d] illustre un organigramme des signaux de contrôle de la cellule mémoire suite à la lecture d'un état logique haut (x=1) par le circuit de traitement selon le quatrième mode de réalisation de l'invention.
[Fig. 5] illustre une vue en coupe d'un exemple d'un composant élémentaire d'une cellule mémoire résistive à filament conducteur variable compatible avec l'invention.
[Fig. 6a] illustre un schéma électrique d'un cinquième mode de réalisation du circuit de traitement selon l'invention connecté à N=3 cellules mémoire résistive à filament conducteur variable.
[Fig. 6b] illustre les étapes de fonctionnement du circuit de traitement selon cinquième mode de réalisation de l'invention pour réaliser une opération logique élémentaire.

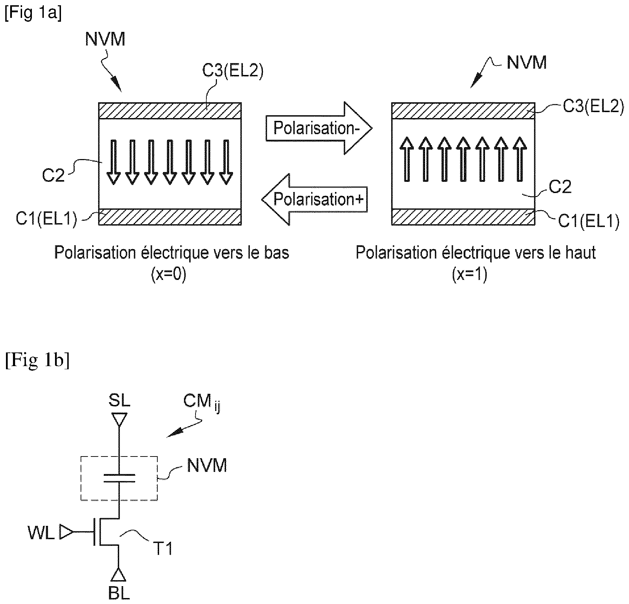

L'invention est compatible avec une matrice mémoire de type ferroélectrique à polarisation électrique variable ou de type résistif à filament conducteur variable ou une matrice de mémoires mixtes résistive et capacitive. Nous allons commencer par décrire l'invention dans un contexte de circuit de stockage à mémoires de type ferroélectrique à polarisation électrique variable. La figure 1a présente un exemple structurel d'un composant élémentaire NVM d'une cellule mémoire ferroélectrique à polarisation électrique variable, plus précisément un composant de type FeRAM.

Dans l'exemple illustré, le composant élémentaire NVM se compose de l'empilement de couches minces selon l'ordre suivant : une première couche C1 en un matériau électriquement conducteur formant une première électrode EL1 ; une deuxième couche C2 en un matériau diélectrique et ferroélectrique et une troisième couche C3 en matériau électriquement conducteur formant une seconde électrode EL2. On dénomme la deuxième couche C2 dans la suite de la description la « couche centrale ».

L'empilement de couches minces forme une structure de type MIM (acronyme Metal-Isolant-Metal) agissant comme un élément capacitif à une capacité C. Le caractère ferroélectrique de la couche centrale C2 induit le comportement suivant : lorsqu'une tension électrique positive est appliquée sur l'électrode supérieure EL2, la polarisation des dipôles électriques de la couche centrale est dirigée dans un sens dit « négatif ». Inversement, lorsqu'une tension électrique positive est appliquée sur l'électrode inférieure EL2, la polarisation des dipôles électriques est dirigée dans un sens dit « positif ». Le sens de la polarisation électrique dans la couche centrale C2 correspond à un état d'équilibre maintenu même en l'absence du champ électrique induit par la tension appliquée sur l'une des électrodes EL1 ou EL2, d'où le fonctionnement en mémoire ferroélectrique.

Ainsi, on choisit la convention suivante à titre d'exemple : lorsqu'un composant mémoire NVM est configuré pour stocker une donnée binaire à l'état logique bas (x= 0) on applique temporairement une tension électrique d'écriture sur l'électrode supérieure EL2 (illustré par polarisation +) de manière à obtenir une polarisation dirigée dans un sens « négatif » dans la couche centrale C2. Inversement, lorsqu'un composant mémoire NVM est configuré pour stocker une donnée binaire à l'état logique haut (x= 1) on applique temporairement une tension électrique d'écriture sur l'électrode inférieure EL1 (illustré par polarisation -) de manière à obtenir une polarisation dirigée dans un sens « positif » dans la couche centrale C2.

La figure 1a illustre un composant élémentaire NVM de type FeRAM compatible avec l'invention. Nous soulignons qu'il est possible également de réaliser l'invention avec des composants élémentaires de type jonction à tunnel ferroélectrique FTJ (acronyme du terme anglais Ferroelectric Tunnel Junction) et tout autre type de technologie de mémoire non-volatile ferroélectrique à polarisation électrique variable.

La figure 1b illustre un schéma électrique d'une cellule mémoire CMᵢⱼ ferroélectrique à polarisation électrique variable compatible avec l'invention. La cellule mémoire comprend CMᵢⱼ un composant élémentaire mémoire NVM, un transistor de sélection T1, un premier nœud d'entrée/sortie SL, un second nœud d'entrée/sortie BL et un nœud de sélection WL. La cellule mémoire CMᵢⱼ est destinée à être intégrée dans une matrice comprenant une pluralité de lignes de bits (bit line en anglais), une pluralité de lignes de mot (word line en anglais) et une pluralité de lignes de source (source line en anglais). Le premier nœud d'entrée/sortie SL est destiné à être connecté à une ligne de source associée à la cellule mémoire CMᵢⱼ. Le second nœud d'entrée/sortie BL est destiné à être connecté à une ligne de bits associée à la cellule mémoire CMᵢⱼ. Le nœud de sélection WL est destiné à être connecté à une ligne de mots associée à la cellule mémoire CMᵢⱼ.

Au sein d'une cellule mémoire CMᵢⱼ, le premier nœud d'entrée/sortie SL est connecté à la seconde électrode EL2 du composant élémentaire mémoire NVM. Le transistor de sélection T1 a une grille connectée au nœud de sélection WL. Le transistor de sélection T1 relie la première électrode EL1 du composant élémentaire mémoire NVM au second nœud d'entrée/sortie BL. Le composant élémentaire NVM se comporte comme un élément capacitif présentant une capacité variable selon la direction de la polarisation électrique de la couche ferroélectrique centrale C2. On modélise ainsi la cellule mémoire CMᵢⱼ par une architecture compacte 1C1T. Cela permet une action directe sur les électrodes EL1 et EL2 de l'élément capacitif lorsque le transistor T1 est à l'état passant.

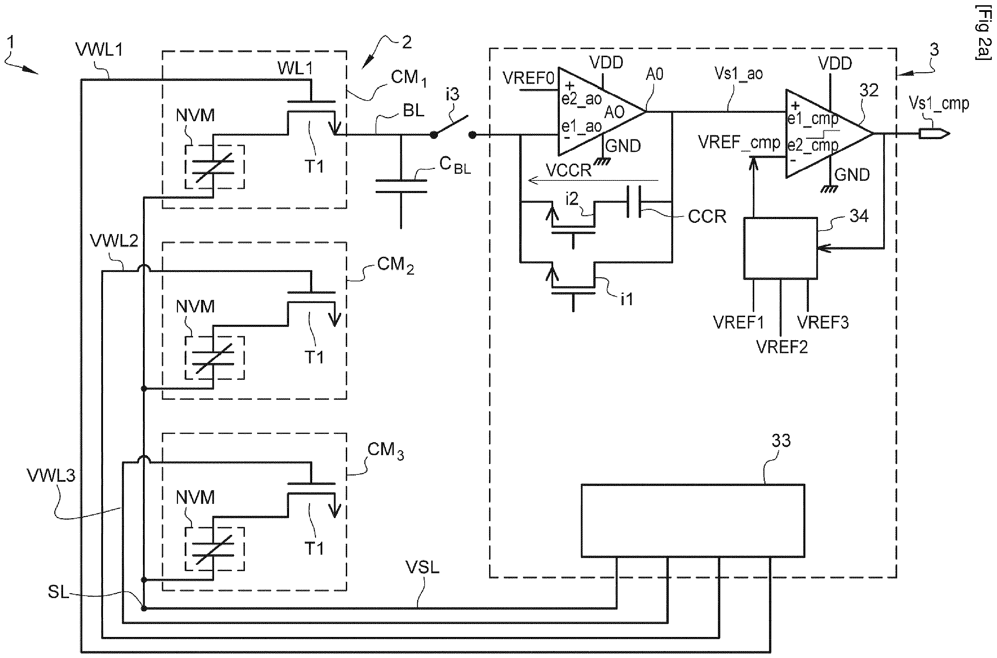

La figure 2a illustre un schéma électrique d'un premier mode de réalisation du circuit de traitement selon l'invention connecté à N=3 cellules mémoire ferroélectrique à polarisation électrique variable. L'exposé d'une opération logique à N=3 opérandes est donné à titre illustratif et non limitatif. L'invention permet de réaliser des opérations logiques élémentaires pour N>=2 opérandes stockés dans autant de cellules mémoires.

Le circuit de stockage selon l'invention comprend une matrice 2 de cellules mémoire CMᵢⱼ tel que décrit dans les figures 1a et 1b et au moins un circuit de traitement de données 3. Par souci de simplification, on ne présente pas toute la matrice mémoire 2 et on se limite à la présentation des cellules mémoires d'entrée CM₁, CM₂ et CM₃ contenant respectivement les données binaires d'entrée x1, x2 et x3.

Les cellules mémoires d'entrée CM₁, CM₂ et CM₃ partagent la même ligne de bit formant un second nœud d'entrée/sortie BL commun auxdites cellules. Les cellules mémoires d'entrée CM₁, CM₂ et CM₃ partagent la même ligne de source formant un premier nœud d'entrée/sortie SL commun auxdites cellules. Les noeuds de sélection WL1, WL2 et WL3 de chacune des cellules mémoires d'entrée CM₁, CM₂ et CM₃ sont distincts.

Le circuit de traitement logique 3 est connecté au second nœud d'entrée/sortie BL commun des cellules mémoires d'entrée CM₁, CM₂ et CM₃ à travers un interrupteur d'activation i3. L'interrupteur d'activation i3 permet d'isoler le nœud BL du circuit de traitement logique 3 en cas de besoin. La capacité parasite C_{BL} vue par le second nœud d'entrée/sortie BL est représentée ici afin de faciliter la compréhension de l'invention.

Le circuit de traitement logique 3 comprend un étage amplificateur à transimpédance capacitive 31 (traduction du terme en anglais Capacitive TransImpedance Amplifier) ; un comparateur 32, une unité de contrôle 34, un circuit séquenceur 33 et un interrupteur de réinitialisation i1.

D'une manière générale, l'étage amplificateur à transimpédance 31 est configuré pour fournir un signal de lecture Vs1_ao analogique pour chacune des opérandes x1, x2, x3. Le comparateur 32 est configuré pour comparer le signal de lecture analogique Vs1_ao à une première tension de référence ajustable VREF_cmp pour générer un signal de sortie numérique Vs1_cmp. L'unité de contrôle 34 est configurée pour ajuster la première tension de référence VREF_cmp à une amplitude choisie parmi N=3 amplitudes prédéterminées VREF1, VREF2, VREF3 tel que VREF1>VREF2>VREF3.

Selon le premier mode de réalisation de l'invention, l'étage amplificateur à transimpédance capacitive 31 comprend un amplificateur opérationnel AO associé à une impédance capacitive de rétroaction (CCR). L'amplificateur opérationnel AO présente une première entrée e1_ao connectée au second nœud d'entrée/sortie BL des cellules mémoires d'entrée ; une seconde entrée e2_ao pour recevoir un second signal de référence VREF0 ; et une sortie s1_ao pour fournir ledit signal de lecture Vs1_ao analogique. L'impédance capacitive de rétroaction CCR est montée entre la sortie s1_ao et la première entrée e1_ao de l'amplificateur opérationnel. Ce type de montage permet de réaliser une lecture directe de la quantité de charges contenue dans le composant élémentaire NVM et non une lecture d'une variation de tension sur le noeud BL. Ce montage permet ainsi de réaliser une opération de lecture dont la précision est indépendante de la capacité parasite C_{BL}.

Dans le mode de réalisation illustré, l'impédance capacitive de rétroaction CCR est réalisée par un unique élément capacitif Cap1. L'impédance capacitive de rétroaction CCR a pour fonction la conversion de la quantité de charges fournie par composant élémentaire NVM (assimilable à un élément capacitif) en une tension électrique appliquée entre la sortie s1_ao et l'entrée e1_ao. Soit Q la quantité de charge fournie par une cellule mémoire d'entrée qui stocke une donnée à un état logique haut. Dans le cas où le circuit de traitement logique 3 est destiné à réaliser des opérations logiques à N opérandes, l'élément capacitif Cap1 est apte à recevoir une quantité de charge supérieure ou égale à NxQ. En d'autres termes, si on assimile le composant élémentaire NVM de chaque cellule mémoire d'entrée ayant une capacité égale à C0, la capacité C1 de l'élément capacitif Cap1 est supérieure ou égale à NxC0.

L'amplificateur opérationnel AO présente une double fonction :
- maintenir le nœud BL à un potentiel fixe égal au potentiel du second signal de référence VREF0 lorsque l'interrupteur d'activation de lecture i3 est passant.
- générer un signal de lecture Vs1_ao analogique ayant une amplitude dépendante de la quantité de charge transmise du composant élémentaire NVM vers l'impédance capacitive de rétroaction CCR lors d'une opération de lecture d'une cellule et lors d'une étape de calcul d'opération logique élémentaire.

Le comparateur 32 présente une première entrée e1_cmp connectée à la sortie s1_ao de l'amplificateur opérationnel ; une seconde entrée e2_cmp pour recevoir ledit premier signal de référence ajustable VREF_cmp; et une sortie s1_cmp pour fournir un signal de lecture Vs1_cmp numérique résultant de la comparaison du signal de lecture Vs1_ao analogique avec le premier signal de référence ajustable VREF_cmp.

L'unité de contrôle 34 est configurée pour commander l'amplitude de la première tension de référence VREF_cmp lors de l'exécution d'une opération logique élémentaire prédéterminée. Il s'agit d'un circuit configuré selon une machine d'état implémentée à l'aide de portes logiques. L'action de l'unité de contrôle 34 sur la première tension de référence VREF_cmp sera détaillée dans une section ultérieure.

Optionnellement, le circuit de traitement 3 comprend un premier interrupteur d'activation de rétroaction i2 entre l'impédance capacitive de rétroaction CCR et la première entrée e1_ao de l'amplificateur opérationnel.

Le comparateur 32 et l'amplificateur opérationnel AO sont polarisés chacun par une tension d'alimentation VDD et la masse électrique GND.

Le circuit séquenceur 33 est configuré pour commander l'application :
- d'un signal de contrôle d'écriture et de lecture VSL sur le premier nœud d'entrée/sortie SL de la cellule mémoire associée;
- et d'un signal de sélection VWL1, VWL2, VWL3 sur chaque nœud de sélection WL1, WL2 et WL3 des cellules mémoires d'entrée.

L'interrupteur de réinitialisation i1 est monté entre la sortie s1_ao et la première entrée e1_ao de l'amplificateur opérationnel. Lorsque l'interrupteur de réinitialisation i1 est à l'état passant, l'impédance capacitive de rétroaction CCR est déchargée. Cette décharge induit également la réinitialisation du signal de sortie analogique Vs1_ao à un potentiel égal à celui du second signal de référence VREF0.

Avantageusement, la fermeture de l'interrupteur de réinitialisation i1 permet de dissiper les charges cumulées sur le second nœud d'entrée/sortie BL à cause des courants de fuite. En effet, pour les nœuds technologiques avancés, il y a augmentation des courants de fuite provenant des grilles des transistors de l'amplificateur opérationnel AO connectés au second nœud d'entrée/sortie BL. Ces courants de fuite entrainent une accumulation de charges au niveau de la capacité parasite C_{BL}. Cela induit des fluctuations de potentiel au niveau du second nœud d'entrée/sortie BL. D'où l'intérêt spécifique de l'interrupteur de réinitialisation i1 dans ce cas de figure.

L'ensemble des interrupteurs i1, i2 et i3 sont commandés par des moyens de contrôle non représentés pour simplifier l'illustration. Les interrupteurs i1, i2 et i3 sont réalisés par des transistors CMOS à titre d'exemple.

Afin de réaliser une opération logique élémentaire ayant pour opérandes les données x1, x2 et x3, le circuit de traitement logique 3 selon le premier mode de réalisation est configuré pour réaliser les étapes détaillées dans l'organigramme de la figure 2a. L'interrupteur i3 est fermé pour établir la connexion entre les cellules mémoires d'entrée et le circuit de traitement logique 3.

La première étape (i) est une étape de réinitialisation obtenue par la configuration suivante : l'interrupteur de réinitialisation i1, l'interrupteur d'activation de rétroaction i2 sont fermés. Le séquenceur 33 génère un signal de sélection VWL de manière à mettre le transistor de sélection T1 à un état bloquant. Le séquenceur 33 génère un signal de contrôle d'écriture et de lecture VSL sur le premier nœud d'entrée/sortie SL égal à la masse électrique. De plus, l'unité de contrôle 34 est configurée pour ajuster la première tension de référence VREF_cmp à l'amplitude maximale VREF1. L'amplitude maximale sert à détecter une variation d'amplitude minimale de la tension de sortie analogique Vs1_ao lorsque un état logique haut est lu.

Cette étape (i) permet de décharger impédance capacitive de rétroaction CCR et de polariser la première entrée e1_ao de l'amplificateur opérationnel au second signal de référence VREF0. Ainsi suite à la réinitialisation, le nœud d'entrée/sortie BL et la sortie s1_ao sont polarisés au second signal de référence VREF0 (VBL= Vs1_ao= VREF0) ; la tension au bornes de l'impédance capacitive de rétroaction CCR est nulle ; la tension de référence du comparateur 32 est à VREF1 ; et la sortie du comparateur s1_cmp est à un état logique bas (Vs1_cmp=0).

La deuxième étape (ii) est une étape de lecture de la première cellule mémoire d'entrée CM₁. L'interrupteur de réinitialisation i1 est ouvert, les interrupteurs i2 et i3 sont fermés (état passant) et seul le transistor de sélection T1 de la première cellule mémoire d'entrée CM₁ est à l'état passant. Le séquenceur 33 est configuré au cours de cette étape pour appliquer un signal de sélection VWL1 permettant de mettre le transistor de sélection T1 à l'état passant (un front montant dans le cas d'un NMOS par exemple. Les transistors de sélection de la deuxième et la troisième cellule mémoire d'entrée sont maintenu à l'état bloquant. Il en résulte la création d'un chemin de connexion entre le composant élémentaire NVM et l'élément capacitif de rétroaction CCR. De plus, le séquenceur 33 est configuré pour appliquer un signal de contrôle de lecture VSL positif sur le premier nœud d'entrée/sortie SL. Il en résulte l'application d'une différence de potentiel quasi nulle aux bornes du composant élémentaire NVM. Ainsi, la combinaison de la tension quasi nulle aux bornes du composant élémentaire NVM et sa connexion avec l'élément capacitif de rétroaction CCR induit un transfert des charges préalablement stockés dans le composant élémentaire NVM vers l'élément capacitif de rétroaction CCR. La quantité de charge transférée dépend de l'état logique préalablement stocké dans la première mémoire d'entrée CM₁. Cela induit une variation de la tension électrique VCCR aux bornes de l'impédance capacitive de rétroaction CCR. La valeur de la tension électrique aux bornes de l'impédance capacitive de rétroaction CCR dépend de la quantité de charges fournie par le composant élémentaire NVM. Cela induit une variation du signal de sortie analogique Vs1_ao qui passe à VREFO-VCCR.

L'amplitude VREF1 est choisie de manière à obtenir le comportement décrit ci-dessous selon le contenu d'une cellule mémoire d'entrée en lecture. Dans le cas où x=1 est stockée dans le composant élémentaire NVM, on obtient Vs1_ao= VREFO-VCCR < VREF1 avec VCCR de l'ordre de quelques centaines de millivolts. On obtient ainsi Vs1_cmp=VDD correspondant à un niveau logique haut. Inversement, le cas où x=0 est stockée dans le composant élémentaire NVM, on obtient Vs1_ao= VREFO-VCCR > VREF1 et donc Vs1_cmp=GND correspondant à un niveau logique bas. Dans le cas illustré, le comparateur 32 est un circuit comparateur inverseur. Inversement, il est envisageable d'implémenter un circuit comparateur non inverseur selon les choix de conception de l'Homme du métier.

Il convient de souligner que les charges sont transférées totalement vers l'impédance capacitive de rétroaction CCR lors de cette étape. La capacité parasite C_{BL} ne reçoit pas ces charges car elle est maintenue à une tension égale à VREF0 grâce à l'amplificateur opérationnel AO durant toute l'opération. Le circuit de traitement 3 selon l'invention permet ainsi de réaliser une opération de lecture dans le domaine des charges indépendante de la valeur de la capacité parasite C_{BL}.

Il en résulte l'obtention de la configuration suivante à l'issue de l'étape ii): dans le cas où x=0 est stockée dans le composant élémentaire NVM, une quantité de charge Q₀ quasi nulle est accumulée dans l'impédance capacitive de rétroaction CCR. Dans le cas où x=1 est stockée dans le composant élémentaire NVM, une quantité de charge Q₁ >> Q₀ est accumulée dans l'impédance capacitive de rétroaction CCR.

L'unité de contrôle 34 reçoit le signal de sortie numérique Vs1_cmp correspondant au résultat de lecture de la première cellule mémoire à l'issue de l'étape précédente.

La troisième étape (iii) consiste en une étape d'ajustement de la première tension de référence VREF_cmp par l'unité de contrôle 33 en ajustant l'amplitude de la première tension de référence selon le résultat de l'étape de lecture précédente. Si la donnée lue est x1=0, l'unité de contrôle 33 est configurée pour maintenir la première tension de référence VREF_cmp à son état actuel à savoir VREF1 dans ce cas. Si la donnée lue est x1=1, l'unité de contrôle 33 est configurée pour ajuster l'amplitude de la première tension de référence VREF_cmp au palier d'amplitude suivant parmi la suite des N amplitudes VREF1 à VREF3.

Suite à cette étape d'ajustement, l'étape de lecture ii) est réitérée pour la deuxième cellule mémoire d'entrée CM₂. Nous rappelons que la configuration initiale du circuit de traitement 3 avant l'étape de lecture de la deuxième cellule mémoire d'entrée CM₂ dépend de la valeur logique lue dans la première cellule mémoire d'entrée CM₁. Deux scénarii sont alors possibles :
- Si x1=0, la première tension de référence VREF_cmp est maintenue à VREF1 et le déroulement de l'étape de lecture ii) de la deuxième cellule mémoire d'entrée CM₂ est identique à celui décrit pour la première cellule mémoire d'entrée CM₁.
- Si x1=1, la première tension de référence VREF_cmp est polarisée à VREF2. Cela permet de configurer le comparateur 32 pour basculer à un état logique haut suite à l'accumulation d'une quantité de charges égale à 2xQ₁ (si x1=1 et x2=1) mais aussi pour générer un signal de sortie numérique bas suite à l'accumulation d'une quantité de charges égale à 1xQ₁ (si x1=1 et x2=0).

Ensuite l'étape d'ajustement (iii) de la première tension de référence VREF_cmp est réitérée. Suite à la lecture du contenu de la deuxième cellule mémoire d'entrée CM₂, l'unité de contrôle réagit de la manière suivante :
- si x1=1 et x2=1, la première tension de référence VREF_cmp est ajustée au palier d'amplitude suivant parmi la suite des N amplitudes à savoir, VREF_cmp = VREF3 .
- si x1=1 et x2=0, la première tension de référence VREF_cmp est maintenue au palier d'amplitude actuel parmi la suite des N amplitudes à savoir, VREF_cmp = VREF2 .
- si x1=0 et x2=0, la première tension de référence VREF_cmp est maintenue au palier d'amplitude actuel parmi la suite des N amplitudes à savoir, VREF_cmp = VREF1.

De même, suite à cette deuxième itération de l'étape d'ajustement, l'étape de lecture ii) est réitérée pour la troisième cellule mémoire d'entrée CM₃.

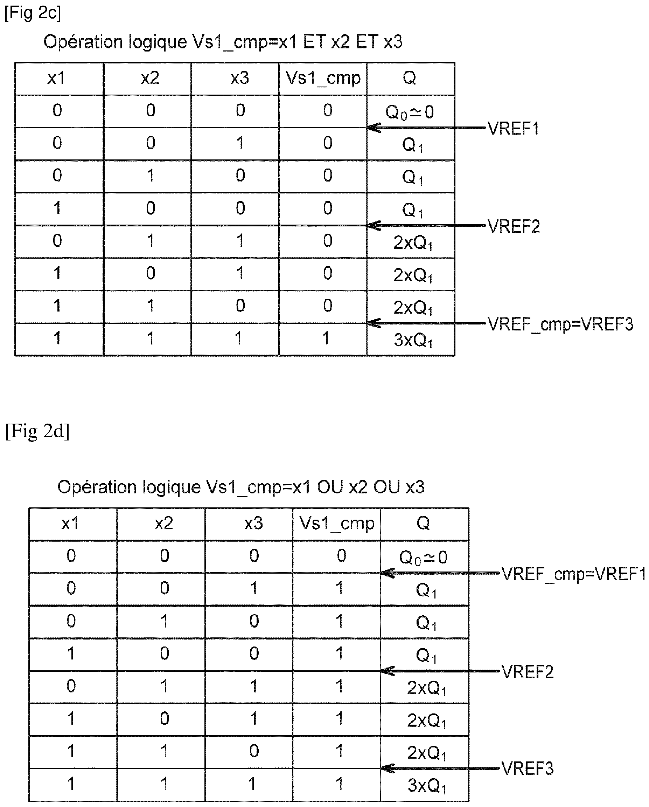

D'un point de vu analogique, chaque combinaison logique des données correspond à une quantité de charges cumulée dans l'impédance capacitive de rétroaction CCR. A l'issue des N itérations des étapes ii) et iii), l'élément capacitif Cap1 stocke une quantité de charge égale à kxQ₁, avec k le nombre de cellules mémoire d'entrée contenant des données logiques à un état haut « 1 ». Les tableaux des figures 2c et 2d illustrent l'état de charge de l'impédance capacitive de rétroaction suite à trois itérations des étapes de lecture (ii) et d'ajustement (iii) pour les trois cellules mémoires d'entrée.

L'étape suivante consiste en une étape d'ajustement de la première tension de référence VREF_cmp selon le type de l'opération logique pour générer un signal de sortie numérique Vs1_cmp correspondant au résultat de l'opération logique.

Par exemple, si l'opération logique à réaliser est de type ET, cela revient à générer un signal de sortie numérique Vs1_cmp=1 uniquement lorsque x1=x2=x3=1. Cela correspond à la détection de l'accumulation d'une quantité de charge de 3xQ₁ dans l'impédance capacitive de rétroaction CCR à l'issu de trois opérations de lecture successives. Ainsi, pour réaliser une opération logique de type ET, l'unité de contrôle 34 est configurée pour polariser la première tension de référence VREF_cmp à l'amplitude correspondant au palier minimal VREF3. Ainsi, la sortie du comparateur 32 ne bascule vers un état logique haut que lorsque Vs1_ao= VREFO-VCCR < VREF3.

L'amplitude de la tension de référence VREF3 est l'amplitude minimale parmi VREF1 à VREF3. L'amplitude minimale VREF3 sert à détecter une variation d'amplitude maximale de la tension de sortie analogique Vs1_ao. En effet, Plus il y a des charges cumulées dans l'impédance capacitive de rétroaction CCR, plus la tension Vs1_ao= VREFO-VCCR est basse. Donc l'amplitude minimale VREF3 est l'amplitude de la tension de référence pour laquelle le comparateur 32 est apte à detecter la variation de l'amplitude de la tension de sortie analogique Vs1_ao.

Alternativement, si l'opération logique à réaliser est de type OU, cela revient à générer un signal de sortie numérique Vs1_cmp=0 uniquement lorsque x1=x2=x3=0. Cela correspond à la détection de l'accumulation d'une quantité de charge de Q₀ quasi nulle dans l'impédance capacitive de rétroaction CCR à l'issu de trois opérations de lecture successives. Ainsi, pour réaliser une opération logique de type OU, l'unité de contrôle 34 est configurée pour polariser la première tension de référence VREF_cmp à l'amplitude correspondant au palier minimal VREF1. Ainsi, la sortie du comparateur 32 ne bascule vers un état logique bas que lorsque Vs1_ao= VREFO-VCCR < VREF1.

Nous avons ainsi réalisé des opérations logiques élémentaires avec N opérandes stockées dans des cellules mémoires de la matrice mémoire dans le circuit de stockage lui-même.

Avantageusement, il est possible de réaliser des opérations logiques plus complexes (de type OU exclusif par exemple) en reprenant le même principe de fonctionnement basé sur l'accumulation de charges en combinaison avec la commande de la tension de seuil du comparateur 32.

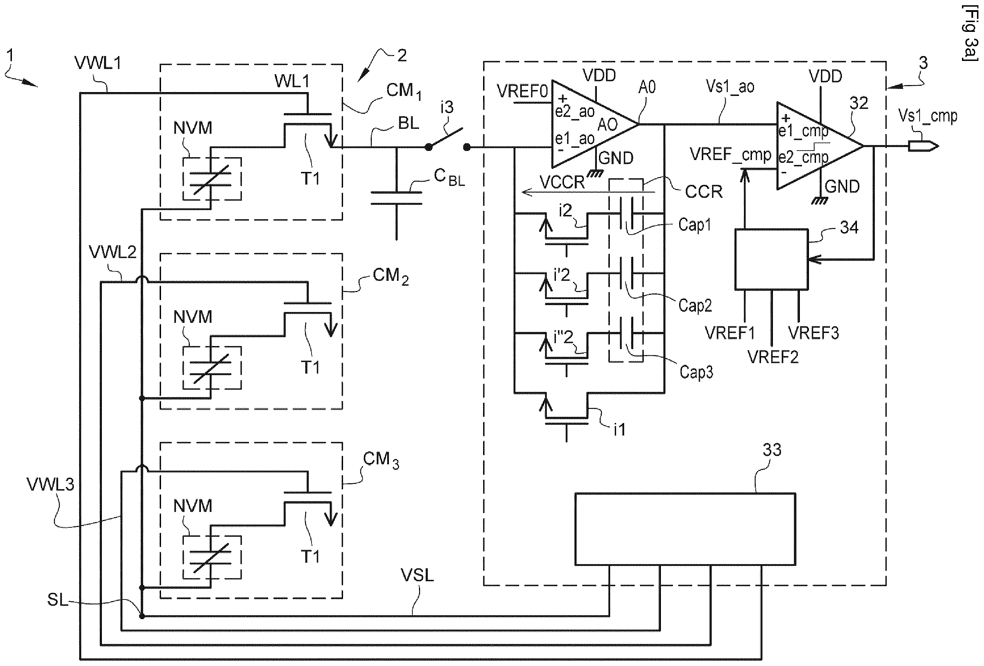

La figure 3a illustre un schéma électrique d'un deuxième mode de réalisation du circuit de traitement 3 selon l'invention connecté à N=3 cellules mémoire ferroélectrique à polarisation électrique variable. Structurellement, le deuxième mode de réalisation se distingue du premier mode de réalisation par la réalisation de l'impédance capacitive de rétroaction CCR. En effet, dans le cas illustré, l'impédance capacitive de rétroaction CCR est réalisée par une pluralité d'éléments capacitifs Cap1, Cap2 et Cap3 montés en parallèle entre la sortie s1_ao et la première entrée e1_ao de l'amplificateur opérationnel AO.

Pour chaque élément capacitif parmi Cap1, Cap2 et Cap3, le circuit de traitement 3 comprend en outre un interrupteur d'activation de rétroaction (i2, i2'et i2" ici réalisés par des transistors) entre l'élément capacitif de rétroaction associé et la première entrée e1_ao de l'amplificateur opérationnel. Ainsi, pendant une opération de lecture, chaque élément capacitif de rétroaction est dédié pour recevoir les charges fournies par une cellule mémoire d'entrée associée. Soit Q la quantité de charge fournie par une cellule mémoire d'entrée qui stocke une donnée à un état logique haut. Le premier élément capacitif Cap1 est apte à recevoir une quantité de charge inférieure ou égale à 1xQ ; le deuxième élément capacitif Cap2 est apte à recevoir une quantité de charge inférieure ou égale à 2xQ ; et le troisième élément capacitif Cap3 est apte à recevoir une quantité de charge inférieure ou égale à 3xQ.

Ainsi, lorsque le circuit de traitement 3 est configuré pour réaliser une opération logique élémentaire mettant en œuvre 3 opérandes, l'interrupteur d'activation de rétroaction i" associé au troisième élément capacitif Cap3 est fermé et les deux autres interrupteurs d'activation de rétroaction i et i' sont ouverts. La connexion électrique est établie entre le troisième élément capacitif Cap3 et le second nœud d'entrée/sortie BL commun aux cellules mémoire d'entrée.

De même, si le nombre d'opérandes est égal à 2, la connexion est établie entre le deuxième élément capacitif Cap2 et le second nœud d'entrée/sortie BL commun aux cellules mémoire d'entrée.

Dans le cas où le circuit de traitement 3 est configuré pour réaliser uniquement une opération de lecture d'une donnée à partir d'une cellule mémoire d'entrée, le premier élément capacitif Cap1 est suffisant. Ainsi, le circuit de traitement 3 est configuré pour sélectionner le premier élément capacitif Cap1 pour recevoir les charges fournies par la cellule mémoire d'entrée à lire.

Ainsi, ce mode de réalisation permet l'adaptation de la valeur de la capacité de l'impédance capacitive de rétroaction au nombre d'opérandes de l'opération logique élémentaire à réaliser.

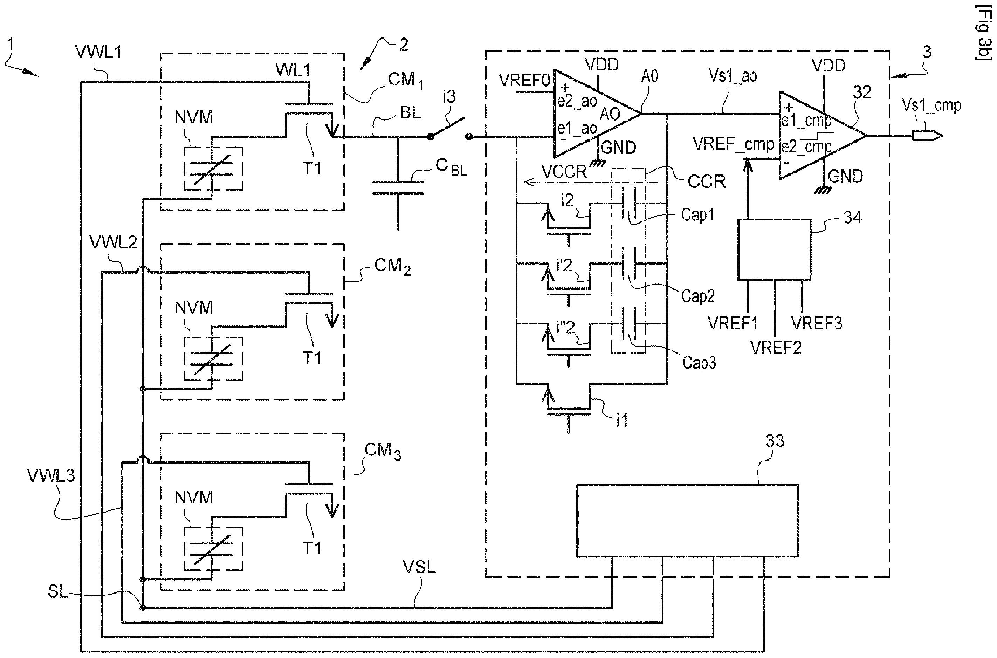

La figure 3b illustre un schéma électrique d'un troisième mode de réalisation du circuit de traitement 3 selon l'invention connecté à N=3 cellules mémoire ferroélectrique à polarisation électrique variable. Le troisième mode de réalisation se distingue du deuxième mode de réalisation par le dimensionnement des éléments capacitifs Cap1, Cap2 et Cap3. En effet, chaque élément capacitif parmi Cap1, Cap2 et Cap3 présente une capacité supérieure ou égale à celle du composant élémentaire d'une cellule mémoire d'entrée. Chaque élément capacitif parmi Cap1, Cap2 et Cap3 est apte à recevoir une quantité de charge supérieure ou égale à 1xQ. Le premier élément capacitif Cap1 est destiné à la réception des charges fournie par la première cellule mémoire d'entrée CM₁ lors de sa lecture. Le deuxième élément capacitif Cap2 est destiné à la réception des charges fournie par la deuxième cellule mémoire d'entrée CM₂ lors de sa lecture. Le troisième élément capacitif Cap3 est destiné à la réception des charges fournie par la troisième cellule mémoire d'entrée CM₃ lors de sa lecture.

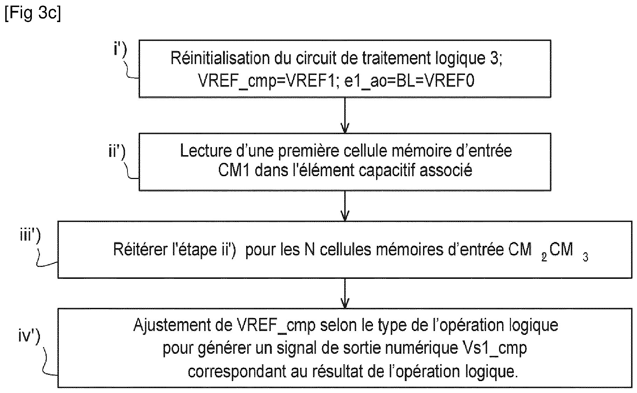

La figure 3c illustre les étapes de fonctionnement du circuit de traitement selon un troisième mode de réalisation de l'invention pour réaliser une opération logique élémentaire.

La première étape (i') est une étape de réinitialisation identique à l'étape de réinitialisation de la figure 2a.

L'étape suivante (ii') consiste en la lecture de la première cellule mémoire d'entrée CM₁ tout en sélectionnant uniquement le premier élément capacitif Cap1. Le mécanisme de lecture reste le même par rapport à ce qui a été détaillé précédemment. Il en résulte l'accumulation des charges fournies par la première cellule mémoire d'entrée CM1 dans le premier élément capacitif Cap1.

L'étape suivante consiste en la lecture de la deuxième cellule mémoire d'entrée CM₂ tout en sélectionnant uniquement le deuxième élément capacitif Cap2. Le mécanisme de lecture reste le même par rapport à ce qui a été détaillé précédemment. Il en résulte l'accumulation des charges fournies par la deuxième cellule mémoire d'entrée CM₂ dans le deuxième élément capacitif Cap2.

L'étape suivante consiste en la lecture de la troisième cellule mémoire d'entrée CM₃ tout en sélectionnant uniquement le troisième élément capacitif Cap3. Le mécanisme de lecture reste le même par rapport à ce qui a été détaillé précédemment. Il en résulte l'accumulation des charges fournies par la troisième cellule mémoire d'entrée CM₃ dans le troisième élément capacitif Cap3.

L'avantage de ce mode de réalisation est qu'il n'y a pas besoin d'ajuster l'amplitude de la première tension de référence ajustable VREF_cmp selon le résultat de lecture. Cela est possible grâce à la distribution de charges résultantes des opérations de lecture successive sur des éléments capacitifs distincts.

La dernière étape iv') consiste en une étape d'ajustement de la première tension de référence VREF_cmp selon le type de l'opération logique de la même manière décrite préalablement. Pendant cette étape, l'ensemble des interrupteurs i2, i2' et i2" sont à l'état passant pour évaluer l'ensemble des quantités de charges réparties sur les trois éléments capacitifs.

Dans la section suivante, nous allons décrire un mode de réalisation de l'invention permettant de résoudre le problème de la lecture destructive des mémoires de type ferroélectrique à polarisation électrique variable. En effet, lors d'un accès en lecture, le composant élémentaire NVM reçoit une tension électrique de lecture sur l'électrode supérieure de manière à la réécrire à un état logique bas (x=0). On observe ensuite la dynamique de la transition suite à l'application de la tension de lecture. Si les dipôles électriques de la couche centrale sont préalablement polarisés avec une orientation dans un sens « positif » (x=1), une quantité de charges électriques relativement importante sera émise par le dispositif pendant la transition. Inversement, si les dipôles électriques de la couche centrale sont préalablement polarisés avec une orientation dans un sens « négatif » (x=0), la quantité de charges délivrées pendant la transition est inférieure. Il en résulte que la procédure de lecture consiste à estimer la quantité de charges émises lors d'une polarisation à un état logique bas (x=0) et qu'elle efface donc la valeur logique de la donnée stockée.

Dans ce contexte, un problème à résoudre est la destruction du contenu logique d'une cellule mémoire ferroélectrique à polarisation électrique variable suite à une opération de lecture.

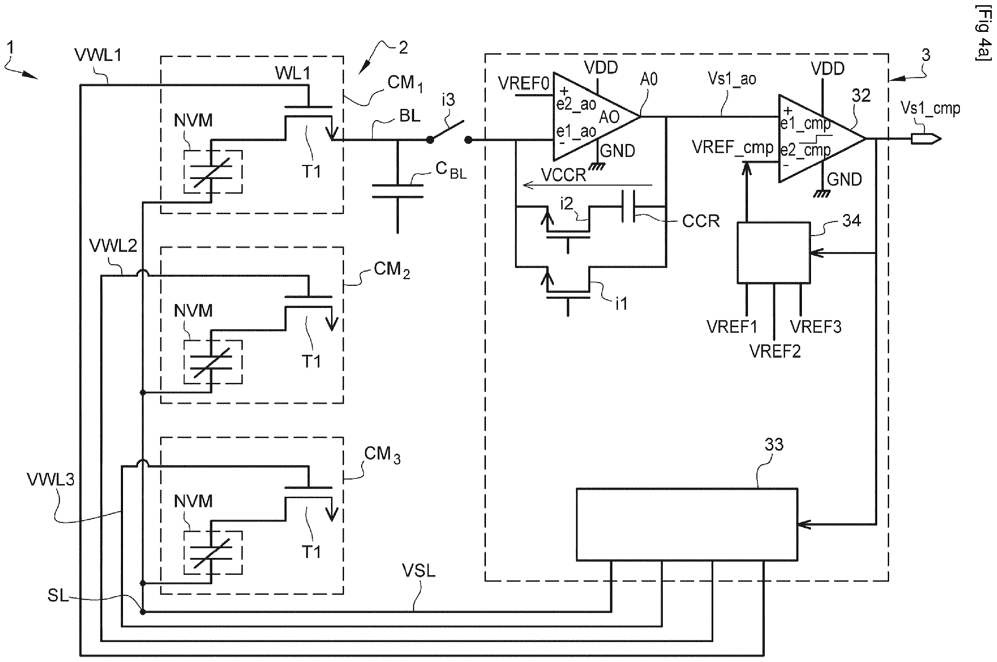

La figure 4a illustre un schéma électrique d'un quatrième mode de réalisation du circuit de traitement 3 permettant de résoudre le problème de lecture destructive.

Dans ce mode de réalisation, le séquenceur 33 reçoit le signal de sortie numérique Vs1_cmp de manière à mettre en place une boucle de rétroaction permettant de réaliser une opération de réécriture par le circuit de lecture lui-même. Cela permet de s'affranchir des problèmes de lecture destructive sans complexifier le circuit. De plus, l'action du séquenceur permet de réaliser la réécriture sans transférer les données à des mémoires tampons externes.

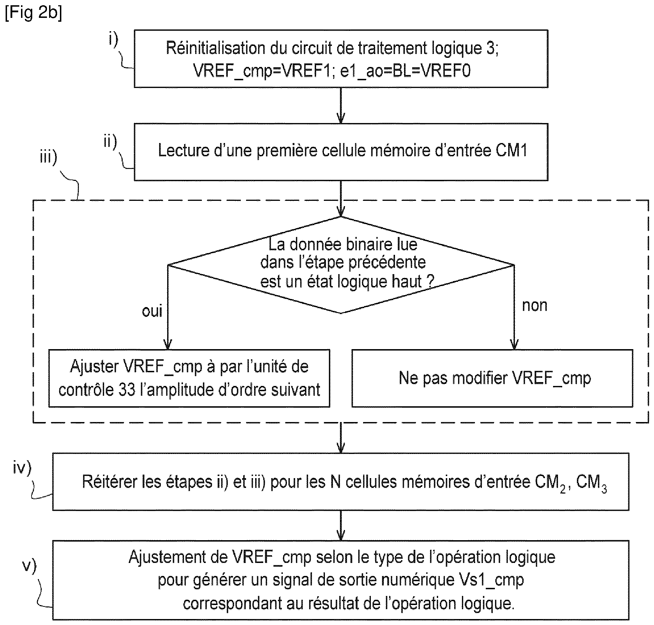

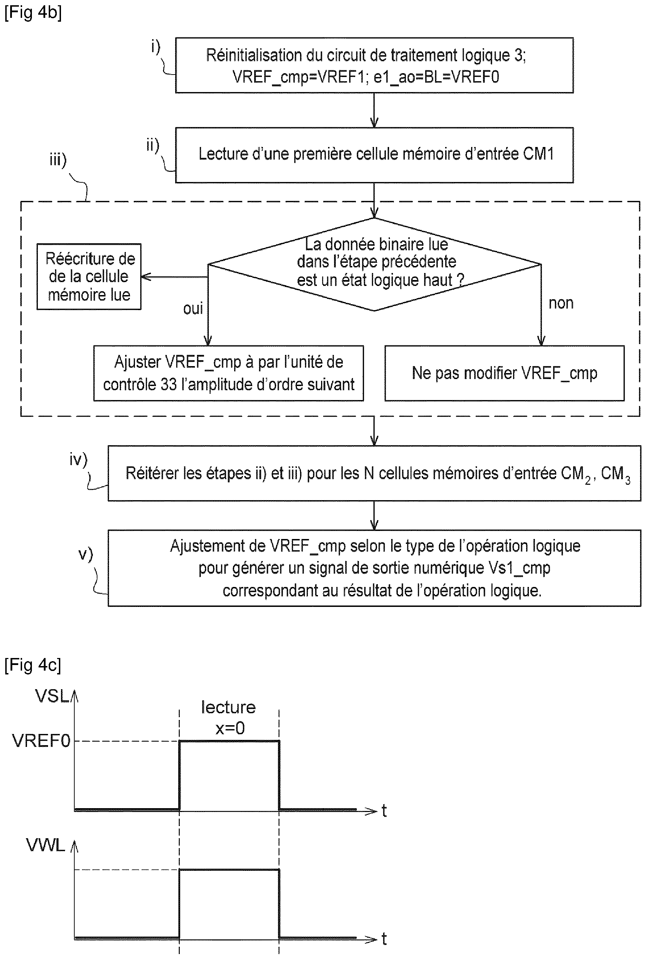

La figure 4b illustre les étapes de fonctionnement du circuit de traitement 3 selon le quatrième mode de réalisation. Le procédé illustré se distingue de celui décrit à la figure 2b par l'ajout d'une étape de réécriture après chaque opération de lecture selon le résultat logique de ladite opération. Nous rappelons que l'opération de réécriture n'est requise que dans le cas où la donnée lue correspond à un état logique haut. Nous allons décrire le déroulement d'une étape de réécriture appliquée sur une cellule mémoire d'entrée.

La figure 4c illustre un organigramme des signaux de contrôle de la cellule mémoire d'entrée suite à la lecture d'un état logique bas (x=0) par le circuit de traitement 3. Dans ce cas, le séquenceur 33 reçoit le signal de sortie numérique Vs1_cmp=0. En réponse à ce résultat, le séquenceur 33 est configuré pour émettre un front descendant simultanément sur les nœuds SL et WL de la cellule mémoire en cours de lecture. Cela permet d'isoler le composant élémentaire NVM du nœud BL et de maintenir l'état logique dudit composant élémentaire à x=0 obtenu suite à l'opération de lecture. (par pompage des charges lors de la lecture).

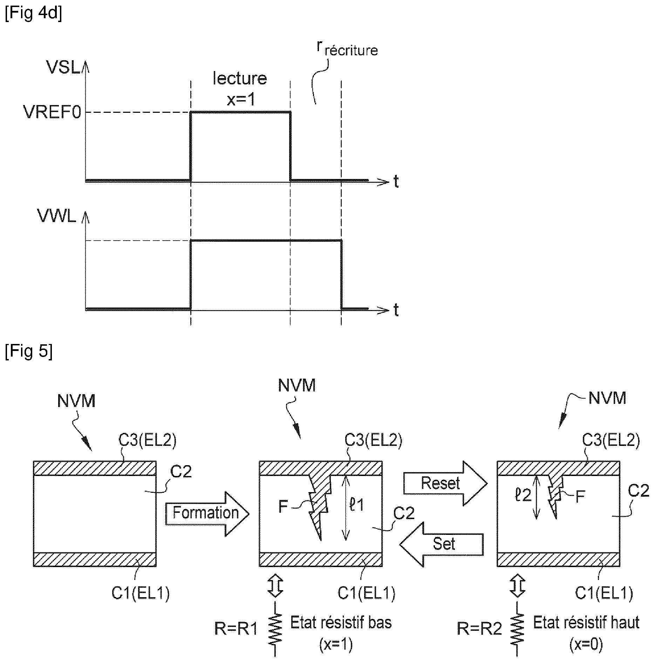

Alternativement, la figure 4d illustre un organigramme des signaux de contrôle de la cellule mémoire d'entrée suite à la lecture d'un état logique haut (x=1) par le circuit de traitement 3. Dans ce cas, le séquenceur 33 reçoit le signal de lecture numérique Vs1_cmp=VDD (x=1). En réponse à ce résultat, le séquenceur 33 est configuré pour appliquer un front descendant sur le nœud d'entrée/sortie SL tout en maintenant le nœud de sélection WL à un état haut. Il en résulte la combinaison suivante :
- D'une part, le premier nœud d'entrée sortie SL est à un potentiel bas (de préférence nul) sous l'action du séquenceur 33 ;
- D'autre part, le second nœud d'entrée/sortie BL est à un potentiel électrique haut égal à VREF0 sous l'action de l'amplificateur opérationnel AO ; le transistor T1 étant à l'état passant ;

Cela correspond à l'application d'une tension d'écriture SET sur le composant élémentaire NVM comme expliqué dans la figure 1a. Ainsi, une opération de réécriture de la valeur logique x=1 a été effectuée via l'action du séquenceur 33 permettant de réaliser une opération de réécriture par le circuit de lecture lui-même. Cela permet de s'affranchir des problèmes de lecture destructive sans complexifier le circuit.

Nous allons décrire l'invention dans un contexte de circuit de stockage à mémoires de type résistive à filament conducteur variable. La figure 5 présente un exemple structurel d'un composant élémentaire NVM d'une cellule mémoire résistive à filament conducteur variable compatible avec l'invention.

Le fonctionnement résistif à filament conducteur variable nécessite la formation d'un filament conducteur F à travers au moins une partie de la couche centrale C2, isolante électriquement.

Initialement, le composant élémentaire NVM est une structure de type MIM (métal, isolant, métal) présentant une résistance infinie entre les deux électrodes EL1 et EL2. Afin de reconfigurer le composant élémentaire NVM selon un fonctionnement en mémoire résistive, il faut former le filament F partant de l'électrode supérieure EL2 à travers au moins une partie du volume de la couche centrale C2. La formation du filament permet d'obtenir une résistance variable en modulant la longueur I du filament conducteur formé. Pour former le filament, on applique une tension électrique de formation sur l'électrode supérieure EL2. La tension électrique de formation présente une amplitude et/ou une durée suffisamment élevée afin d'entrainer la génération de lacunes d'oxygène dans la couche centrale C2. En effet, la tension électrique de formation appliquée doit dépasser une valeur prédéterminée de manière à arracher des ions oxygène du réseau cristallin de la couche centrale en oxyde métallique qui vont migrer vers l'électrode supérieure EL2 et former ainsi un filament conducteur F à travers la couche centrale constitué des lacunes d'oxygène.

Une fois le filament conducteur F formé, on obtient le comportement d'élément résistif à une résistance variable R selon la longueur I du filament conducteur F. Lorsqu'une tension électrique positive est appliquée sur l'électrode inférieure EL1, c'est la réaction inverse qui se produit et des ions oxygènes vont venir combler une partie des lacunes d'oxygène formant le filament conducteur. Il en résulte une réduction de la longueur du filament conducteur. Ainsi, la résistance de l'élément résistif augmente. On parle d'un état résistif haut et d'une opération d'écriture de type RESET. Inversement, lorsqu'une tension électrique positive est appliquée sur l'électrode supérieure EL2, la longueur du filament conducteur F s'accroît par le même mécanisme décrit pour l'opération de formation du fil. Ainsi, la résistance de l'élément résistif diminue. On parle d'un état résistif bas et d'une opération d'écriture de type SET.

On choisit la convention suivante à titre d'exemple : lorsqu'un composant mémoire NVM est configuré pour stocker une donnée binaire à l'état logique haut (x= 1) on applique temporairement une tension électrique d'écriture sur l'électrode supérieure EL2 (opération SET) de manière à obtenir un état résistif bas. Inversement, lorsqu'un composant mémoire NVM est configuré pour stocker une donnée binaire à l'état logique bas (x= 0) on applique temporairement une tension électrique d'écriture sur l'électrode inférieure EL1 (opération RESET) de manière à obtenir un état résistif haut.

La lecture d'un composant mémoire NVM résistif consiste à estimer la résistance entre l'électrode supérieure et l'électrode inférieure et à la comparer à une valeur seuil pour déterminer si l'état résistif est un état haut ou bas.

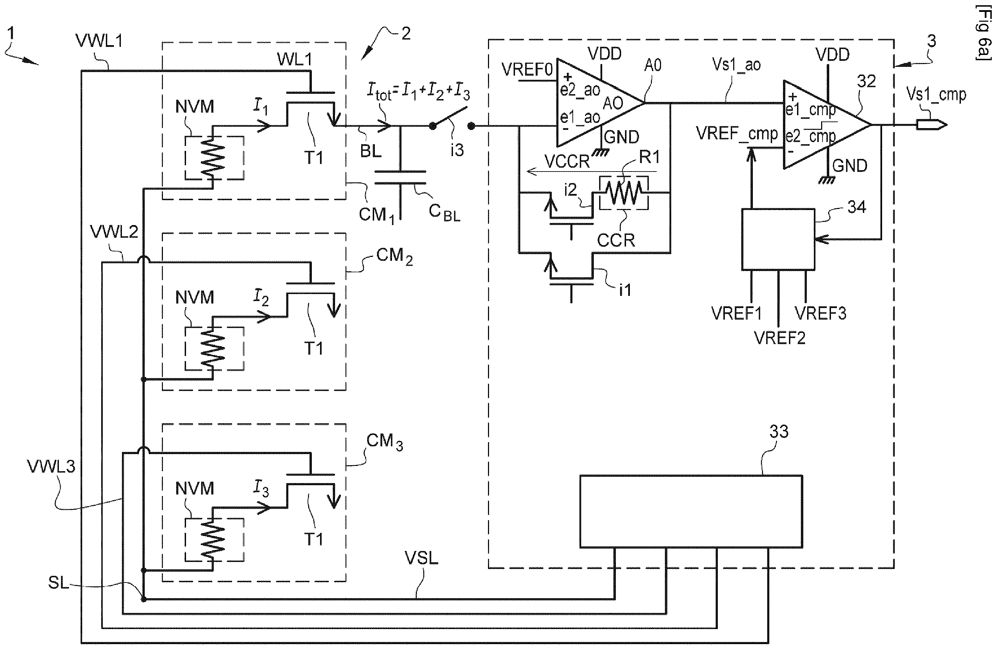

La figure 6a illustre un schéma électrique d'un cinquième mode de réalisation du circuit de traitement 3 connecté à N=3 cellules mémoire résistive à filament conducteur variable. Dans ce cas, l'impédance de rétroaction CCR est réalisé par au moins une résistance de rétroaction R1 monté en parallèle entre la sortie s1_ao et la première entrée e1_ao de l'amplificateur opérationnel AO. Avantageusement, le circuit de lecture 3 comprend un second interrupteur d'activation de rétroaction i4 entre l'impédance résistive de rétroaction RCR et la première entrée e1_ao de l'amplificateur opérationnel A0.

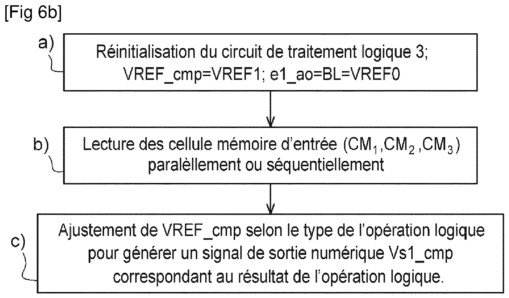

La figure 6b illustre les étapes de fonctionnement du circuit de traitement 3 selon le cinquième mode de réalisation de l'invention pour réaliser une opération logique élémentaire.

La première étape de réinitialisation a) reste inchangée par rapport aux autres modes de réalisations.
La deuxième étape b) consiste en la lecture des cellules mémoire d'entrée CM₁, CM₂, CM₃. Les transistors de sélection T1 des cellules mémoire d'entrée sont mis à l'état passant parallèlement ou séquentiellement. Ensuite, le séquenceur 33 est configuré pour appliquer un signal de contrôle de lecture VSL positif sur leurs premiers nœuds d'entrée/sortie SL. L'amplitude du signal de contrôle de lecture positif VSL est supérieure à celle du second signal de référence VREF0 (potentiel du second nœud BL). Chacun des composants élémentaires résistifs NVM est alors soumis à une différence de potentiel non nulle. Il en résulte la circulation d'un courant électrique I1 à I3 à travers la résistance NVM. Cela induit une addition des courants Iₜₒₜ=I1+I2+I3 dans la résistance de contreréaction R1. L'intensité du courant total Iₜₒₜ dépend du nombre des cellules mémoires d'entrée qui stocke une donnée à un état logique haut (x=1). Cela induit une variation de la tension VRCR aux bornes de l'impédance résistive de rétroaction RCR qui dépend de l'intensité du courant Iₜₒₜ. Il en résulte une variation du potentiel électrique au nœud de sortie s1_ao de l'amplificateur opérationnel AO.

La dernière étape c) consiste à ajuster l'amplitude de la première tension de référence VREF_cmp selon le type de l'opération logique pour générer un signal de sortie numérique Vs1_cmp correspondant au résultat de l'opération logique. Cette étape reste inchangée par rapport aux autres modes de réalisation de l'invention décrit précédemment.

## Revendications

1. Circuit de stockage de données (1) comprenant :
- une matrice (2) de cellules mémoire (CMᵢⱼ) telle que chaque cellule mémoire (CMᵢⱼ) comprend:
• un composant élémentaire de stockage (NVM) non volatile ayant une première électrode (EL1) et une seconde électrode (EL2),
• un premier nœud d'entrée/sortie (SL) connecté à la seconde électrode (EL2), un second nœud d'entrée/sortie (BL), un nœud de sélection (WL);
• et un transistor de sélection (T1) ayant une grille connectée au nœud de sélection (WL) et reliant la première électrode (EL1) au second nœud d'entrée/sortie (BL),
- un circuit de traitement logique (3) configuré pour réaliser une opération logique ayant pour opérandes N données binaires (x1, x2, x3) stockées dans N cellules mémoires d'entrée (CM₁, CM₂, CM₃) avec N≥2; les seconds nœuds d'entrée/sortie (BL) desdites cellules mémoires d'entrée (CM₁, CM₂, CM₃) étant reliés par une ligne de bits commune ; le circuit de traitement logique (3) comprenant :
• un étage amplificateur à transimpédance (31) configuré pour fournir un signal de lecture (Vs1_ao) analogique à partir de la tension de la ligne de bits commune (BL); l'étage amplificateur à transimpédance capacitive (31) comprenant:
∘ un amplificateur opérationnel (AO) ayant : une première entrée (e1_ao) connectée au second nœud d'entrée/sortie (BL) des cellules mémoires d'entrée, et une seconde entrée (e2_ao) pour recevoir une seconde tension de référence (VREFO) ; et une sortie (s1_ao) pour fournir ledit signal de lecture (Vs1_ao) analogique ;
∘ une impédance de rétroaction (CCR) montée entre la sortie (s1_ao) et la première entrée (e1_ao) de l'amplificateur opérationnel ;
• un comparateur (32) destiné à comparer le signal de lecture (Vs1_ao) analogique à une première tension de référence ajustable (VREF_cmp) pour générer un signal de sortie numérique (Vs1_cmp) correspondant au résultat de l'opération logique ;
• une unité de contrôle (34) configurée pour ajuster la tension de référence (VREF_cmp) à une amplitude choisie parmi N amplitudes prédéterminées (VREF1, VREF2, VREF3) distinctes, selon le type de l'opération logique ;
l'impédance de rétroaction (CCR) étant une impédance capacitive et les composants élémentaires de stockage (NVM) des cellules mémoires d'entrée (CM₁, CM₂, CM₃) étant de type ferroélectrique à polarisation électrique variable ; ou
l'impédance de rétroaction (CCR) étant une impédance résistive et les composants élémentaires de stockage (NVM) des cellules mémoires d'entrée (CM₁, CM₂, CM₃) étant de type résistif à filament conducteur variable.

2. Circuit de stockage de données (1) selon la revendication 1 comprenant en outre un séquenceur (33) configuré pour appliquer:
- un signal de contrôle d'écriture et de lecture (VSL) sur le premier nœud d'entrée/sortie (SL) de chacune des cellules mémoires d'entrée (CM₁, CM₂, CM₃) ;
- un signal de sélection (VWL1, VWL2, VWL3) sur le nœud de sélection (WL) de chacune des cellules mémoires d'entrée (CM₁, CM₂, CM₃).

3. Circuit de stockage de données (1) selon l'une quelconque des revendications 1 ou 2 dans lequel les premiers nœuds d'entrée/sortie (SL) desdites cellules mémoires d'entrée (CM₁, CM₂, CM₃) sont reliés par une ligne de source commune.

4. Circuit de stockage de données (1) selon l'une quelconque des revendications 1 à 3 dans lequel le circuit de traitement logique (3) comprend en outre un interrupteur de réinitialisation (i1) monté entre la sortie (s1_ao) et la première entrée (e1_ao) de l'amplificateur opérationnel.

5. Circuit de stockage de données (1) selon l'une quelconque des revendications 1 à 4 dans lequel :
lorsque l'impédance de rétroaction (CCR) est une impédance capacitive et lorsque les composants élémentaires de stockage (NVM) des cellules mémoires d'entrée (CM₁, CM₂, CM₃) sont de type ferroélectrique à polarisation électrique variable, chaque cellule mémoire peut présenter un premier (« 0 ») ou un deuxième (« 1 ») état logique correspondant respectivement à des niveaux différents de charges stockées dans le composant élémentaire de stockage (NVM) associé .

6. Circuit de stockage de données (1) selon la revendication 5 dans lequel chaque composant élémentaire de stockage (NVM) des cellules mémoires d'entrée (CM₁, CM₂, CM₃) présente une première capacité prédéterminée, et dans lequel l'impédance de rétroaction (CCR) est un élément capacitif (C1) ayant une seconde capacité supérieure à N fois ladite première capacité prédéterminée.

7. Circuit de stockage de données (1) selon la revendication 6 dans lequel les N amplitudes prédéterminées (VREF1, VREF2, VREF3) sont ordonnées selon un ordre décroissant, et dans lequel le circuit de traitement logique (3) est configuré pour réaliser une opération logique en exécutant les étapes suivantes :
i) une étape de réinitialisation pour décharger l'élément capacitif (C1), polariser la première entrée (e1_ao) de l'amplificateur opérationnel à la seconde tension de référence (VREFO) et ajuster la première tension de référence (VREF_cmp) à l'amplitude maximale parmi les N amplitudes prédéterminées (VREF1) ;
ii) une étape de lecture d'une première cellule mémoire d'entrée (CM₁) en mettant à l'état passant son transistor de sélection (T1) et en appliquant un signal de contrôle de lecture (VSL) sur son premier nœud d'entrée/sortie (SL) ayant une amplitude sensiblement égale à la seconde tension de référence (VREFO) de sorte à engendrer un transfert de charges depuis le composant élémentaire de stockage (NVM) de la cellule mémoire sélectionnée vers son élément capacitif associé (C1).
iii) une étape d'ajustement de la première tension de référence (VREF_cmp) par l'unité de contrôle (33) en ajustant l'amplitude de la première tension de référence à l'amplitude d'ordre suivant (VREF2) parmi les N amplitudes prédéterminées lorsque la donnée binaire lue dans l'étape précédente est un état logique haut ;
iv) réitérer les étapes ii) et iii) pour les N cellules mémoires d'entrée (CM₂, CM₃) ;
v) une étape d'ajustement de la première tension de référence (VREF_cmp) à une valeur prédéterminée, selon le type de l'opération logique, parmi les N amplitudes par l'unité de contrôle (33) pour générer un signal de sortie numérique (Vs1_cmp) correspondant au résultat de l'opération logique.

8. Circuit de stockage de données (1) selon la revendication 5 dans lequel chaque composant élémentaire de stockage (NVM) des cellules mémoires d'entrée (CM₁, CM₂, CM₃) présente une première capacité prédéterminée, et dans lequel l'impédance de rétroaction (CCR) est réalisée par N éléments capacitifs (C1, C2, C3) montés en parallèle, chaque élément capacitif (C1, C2, C3) étant associé à une cellule mémoire d'entrée (CM₁, CM₂, CM₃) et ayant une seconde capacité supérieure ou égale à ladite première capacité prédéterminée.

9. Circuit de stockage de données (1) selon la revendication 8 dans lequel le circuit de traitement logique (3) est configuré pour réaliser une opération logique en exécutant les étapes suivantes :
i') une étape de réinitialisation pour décharger les éléments capacitifs (C1, C2, C3), polariser la première entrée (e1_ao) de l'amplificateur opérationnel à la seconde tension de référence (VREFO) et ajuster la première tension de référence (VREF1, VREF2, VREF3) à l'amplitude maximale parmi les N amplitudes prédéterminées ;
ii') une étape de lecture d'une première cellule mémoire d'entrée (CM₁) en mettant à l'état passant son transistor de sélection (T1) et en appliquant un signal de contrôle de lecture (VSL) sur son premier nœud d'entrée/sortie (SL) ayant une amplitude sensiblement égale à la seconde tension de référence (VREFO) de sorte à engendrer un transfert de charges depuis le composant élémentaire de stockage (NVM) de la cellule mémoire sélectionnée vers son élément capacitif associé (C1).
iii') réitérer l'étape ii') pour les N cellules mémoires d'entrée (CM₂, CM₃) ;
iv') une étape d'ajustement de la première tension de référence (VREF_cmp) à une valeur prédéterminée, selon le type de l'opération logique, parmi les N amplitudes pour générer un signal de sortie numérique (Vs1_cmp) correspondant au résultat de l'opération logique.

10. Circuit de stockage de données (1) selon l'une quelconques des revendications 5 à 9 dans lequel le circuit séquenceur (33) est configuré pour, suite à la lecture d'une donnée correspondant au second état logique (« 1 ») dans une cellule mémoire sélectionnée, appliquer un signal de contrôle (VSL), sur le premier nœud d'entrée/sortie (SL) de ladite cellule mémoire sélectionnée, ayant une amplitude inférieure à la seconde tension de référence (VREFO) et maintenir le transistor de sélection (T1) de la cellule mémoire sélectionnée à un état passant de sorte à remettre, dans son composant élémentaire de stockage (NVM), un niveau de charges correspondant au second état logique (« 1 »).

11. Circuit de stockage de données (1) selon l'une quelconque des revendications 2 à 10, dans lequel ledit premier état logique («0») correspond à un état non chargé d'un composant élémentaire de stockage (NVM), et dans lequel ledit circuit séquenceur (33) est tel que, suite à la lecture d'une donnée correspondant à un premier état logique (« 0 »), ledit circuit séquenceur (33) est configuré pour rendre non conducteur ledit transistor de sélection (T1) de la cellule mémoire sélectionnée avant de modifier le signal de contrôle (VSL) sur le premier nœud d'entrée/sortie (SL) vers une nouvelle valeur, pour maintenir la cellule mémoire venant d'être lue à un état non chargé.

12. Circuit de stockage de données (1) selon l'une quelconque des revendications 5 à 11 dans lequel le composant élémentaire de stockage (NVM) d'une cellule mémoire d'entrée (CM₁, CM₂, CM₃) est de type FeRAM ou de type jonction à tunnel ferroélectrique FTJ.

13. Circuit de stockage de données (1) selon l'une quelconque des revendications 1 à 4 lequel lorsque l'impédance de rétroaction (CCR) est une impédance résistive et dans lequel les composants élémentaires de stockage (NVM) des cellules mémoires d'entrée (CM₁, CM₂, CM₃) sont de type résistif à filament conducteur variable, le circuit de traitement logique (3) est configuré pour réaliser une opération logique en exécutant les étapes suivantes :
a) une étape de réinitialisation pour polariser la première entrée (e1_ao) de l'amplificateur opérationnel à la seconde tension de référence (VREFO) et ajuster la première tension de référence (VREF_cmp) à l'amplitude maximale (VREF1) parmi les N amplitudes prédéterminées ;
b) une étape de lecture des cellules mémoire d'entrée (CM₁, CM₂, CM₃), en mettant à l'état passant leurs transistors de sélection (T1) parallèlement ou séquentiellement, et en appliquant un signal de contrôle de lecture (VSL) positif sur leurs premiers nœuds d'entrée/sortie (SL) ;
c) une étape d'ajustement de la première tension de référence (VREF_cmp) à une valeur prédéterminée, selon le type de l'opération logique, parmi les N amplitudes, par l'unité de contrôle (33), pour générer un signal de sortie numérique (Vs1_cmp) correspondant au résultat de l'opération logique.

14. Circuit de stockage de données (1) selon l'une quelconque des revendications 7 ou 9 ou 13 dans lequel lors de l'étape d'ajustement de la première tension de référence (VREF_cmp) selon le type de l'opération logique,
l'unité de contrôle (33) est configurée pour ajuster la première tension de référence (VREF_cmp) à l'amplitude minimale(VREF3) parmi les N amplitudes prédéterminées lorsque l'opération logique est de type ET.

15. Circuit de stockage de données (1) selon l'une quelconque des revendications 7 ou 9 ou 13 dans lequel lors de l'étape d'ajustement de la première tension de référence (VREF_cmp) selon le type de l'opération logique,
l'unité de contrôle (33) est configurée pour ajuster la première tension de référence (VREF_cmp) à l'amplitude maximale (VREF1) parmi les N amplitudes prédéterminées lorsque l'opération logique est de type OU.

## Patentansprüche

1. Datenspeicherschaltung (1), Folgendes umfassend:
- eine Matrix (2) von Speicherzellen (CMᵢⱼ), wobei jede Speicherzelle (CMᵢⱼ) Folgendes umfasst:
• eine nichtflüchtige elementare Speicherkomponente (NVM) mit einer ersten Elektrode (EL1) und einer zweiten Elektrode (EL2),
• einen ersten Eingangs-/Ausgangsknoten (SL), der mit der zweiten Elektrode (EL2) verbunden ist, einen zweiten Eingangs-/Ausgangsknoten (BL), einen Auswahlknoten (WL);
• und einen Auswahltransistor (T1) mit einem mit dem Auswahlknoten (WL) verbundenen Gatter, und der die erste Elektrode (EL1) an den zweiten Eingangs-/Ausgangsknoten (BL) anschließt,
- eine logische Verarbeitungsschaltung (3), die konfiguriert ist, um eine logische Operation durchzuführen, die als Operanden N Binärdaten (x1, x2, x3) aufweist, die in N Eingangsspeicherzellen (CM₁, CM₂, CM₃) gespeichert sind, wobei N ≥ 2; wobei die zweiten Eingangs-/Ausgangsknoten (BL) der Eingangsspeicherzellen (CM₁, CM₂, CM₃) durch eine gemeinsame Bitleitung gekoppelt sind; wobei die logische Verarbeitungsschaltung (3) Folgendes umfasst:
• eine Transimpedanzverstärkerstufe (31), die so konfiguriert ist, dass sie ein analoges Lesesignal (Vs1_ao) anhand der Spannung der gemeinsamen Bitleitung (BL) bereitstellt; wobei die kapazitive Transimpedanzverstärkerstufe (31) Folgendes umfasst:
o einen Operationsverstärker (AO) mit: einem ersten Eingang (e1_ao), der mit dem zweiten Eingangs-/Ausgangsknoten (BL) der Eingangsspeicherzellen verbunden ist, und einem zweiten Eingang (e2_ao) zum Empfangen einer zweiten Referenzspannung (VREF0); und einem Ausgang (s1_ao) zum Bereitstellen des analogen Lesesignals (Vs1_ao);
o eine Rückkopplungsimpedanz (CCR), die zwischen dem Ausgang (s1_ao) und dem ersten Eingang (e1_ao) des Operationsverstärkers montiert ist;
• einen Komparator (32), der zum Vergleichen des analogen Lesesignals (Vs1_ao) mit einer ersten einstellbaren Referenzspannung (VREF_cmp) vorgesehen ist, um ein digitales Ausgangssignal (Vs1_cmp) zu erzeugen, das dem Ergebnis der logischen Operation entspricht;
• eine Steuereinheit (34), die so konfiguriert ist, dass sie die Referenzspannung (VREF_cmp) auf eine Amplitude einstellt, die aus N vorbestimmten unterschiedlichen Amplituden (VREF1, VREF2, VREF3) ausgewählt wird, je nach Art der logischen Operation;
wobei die Rückkopplungsimpedanz (CCR) eine kapazitive Impedanz ist und die elementaren Speicherkomponenten (NVM) der Eingangsspeicherzellen (CM₁, CM₂, CM₃) vom ferroelektrischen Typ mit variabler elektrischer Vorspannung sind; oder
wobei die Rückkopplungsimpedanz (CCR) eine ohmsche Impedanz ist und die elementaren Speicherkomponenten (NVM) der Eingangsspeicherzellen (CM₁, CM₂, CM₃) vom Typ Widerstand mit variablem leitendem Filament sind.

2. Datenspeicherschaltung (1) nach Anspruch 1, ferner umfassend eine Ablaufsteuerung (33), die so konfiguriert ist, dass sie Folgendes anlegt:
- ein Schreib- und Lesesteuersignal (VSL) an den ersten Eingangs-/Ausgangsknoten (SL) jeder der Eingangsspeicherzellen (CM₁, CM₂, CM₃);
- ein Auswahlsignal (VWL1, VWL2, VWL3) an den Auswahlknoten (WL) jeder der Eingangsspeicherzellen (CM₁, CM₂, CM₃).

3. Datenspeicherschaltung (1) nach einem der Ansprüche 1 oder 2, wobei die ersten Eingangs-/Ausgangsknoten (SL) der Eingangsspeicherzellen (CM₁, CM₂, CM₃) durch eine gemeinsame Quellenleitung gekoppelt sind.

4. Datenspeicherschaltung (1) nach einem der Ansprüche 1 bis 3, wobei die logische Verarbeitungsschaltung (3) ferner einen Rücksetzschalter (i1) umfasst, der zwischen dem Ausgang (s1_ao) und dem ersten Eingang (e1_ao) des Operationsverstärkers montiert ist.

5. Datenspeicherschaltung (1) nach einem der Ansprüche 1 bis 4, wobei:
wenn die Rückkopplungsimpedanz (CCR) eine kapazitive Impedanz ist und wenn die elementaren Speicherkomponenten (NVM) der Eingangsspeicherzellen (CM₁, CM₂, CM₃) vom ferroelektrischen Typ mit variabler elektrischer Vorspannung sind, jede Speicherzelle einen ersten ("0") oder einen zweiten ("1") logischen Zustand aufweisen kann, der jeweils unterschiedlichen Pegeln von in der zugeordneten elementaren Speicherkomponente (NVM) gespeicherten Ladungen entspricht.

6. Datenspeicherschaltung (1) nach Anspruch 5, wobei jede elementare Speicherkomponente (NVM) der Eingangsspeicherzellen (CM₁, CM₂, CM₃) eine erste vorbestimmte Kapazität aufweist, und wobei die Rückkopplungsimpedanz (CCR) ein kapazitives Element (C1) mit einer zweiten Kapazität ist, die größer als das N-fache der ersten vorbestimmten Kapazität ist.

7. Datenspeicherschaltung (1) nach Anspruch 6, wobei die N vorbestimmten Amplituden (VREF1, VREF2, VREF3) in absteigender Reihenfolge geordnet sind, und wobei die logische Verarbeitungsschaltung (3) so konfiguriert ist, dass sie eine logische Operation durchführt, indem sie die folgenden Schritte ausführt:
i) einen Rücksetzschritt zum Entladen des kapazitiven Elements (C1), Vorspannen des ersten Eingangs (e1_ao) des Operationsverstärkers auf die zweite Referenzspannung (VREFO) und Einstellen der ersten Referenzspannung (VREF_cmp) auf die maximale Amplitude unter den N vorbestimmten Amplituden (VREF1);
ii) einen Leseschritt einer ersten Eingangsspeicherzelle (CM₁), indem ihr Auswahltransistor (T1) in den leitenden Zustand versetzt und ein Lesesteuersignal (VSL) an ihren ersten Eingangs-/Ausgangsknoten (SL) angelegt wird, der eine Amplitude aufweist, die im Wesentlichen gleich der zweiten Referenzspannung (VREFO) ist, um einen Ladungstransfer von dem elementaren Speicherelement (NVM) der ausgewählten Speicherzelle an sein zugeordnetes kapazitives Element (C1) zu bewirken.
iii) einen Einstellschritt der ersten Referenzspannung (VREF_cmp) durch die Steuereinheit (33), indem die Amplitude der ersten Referenzspannung auf die Amplitude der nächsten Ordnung (VREF2) unter den N vorbestimmten Amplituden eingestellt wird, wenn das im vorherigen Schritt gelesene Binärdatenelement ein logischer High-Zustand ist;
iv) Wiederholen der Schritte ii) und iii) für die N Eingangsspeicherzellen (CM₂, CM₃);
v) einen Einstellschritt der ersten Referenzspannung (VREF_cmp) auf einen vorbestimmten Wert, je nach Art der logischen Operation, unter den N Amplituden, durch die Steuereinheit (33), um ein digitales Ausgangssignal (Vs1_cmp) zu erzeugen, das dem Ergebnis der logischen Operation entspricht.

8. Datenspeicherschaltung (1) nach Anspruch 5, wobei jede elementare Speicherkomponente (NVM) der Eingangsspeicherzellen (CM₁, CM₂, CM₃) eine erste vorbestimmte Kapazität aufweist, und wobei die Rückkopplungsimpedanz (CCR) durch N parallel montierte kapazitive Elemente (C1, C2, C3) hergestellt wird, wobei jedes kapazitive Element (C1, C2, C3) einer Eingangsspeicherzelle (CM₁, CM₂, CM₃) zugeordnet ist und eine zweite Kapazität aufweist, die größer als oder gleich der ersten vorbestimmten Kapazität ist.

9. Datenspeicherschaltung (1) nach Anspruch 8, wobei die logische Verarbeitungsschaltung (3) so konfiguriert ist, dass sie eine logische Operation durchführt, indem sie die folgenden Schritte ausführt:
i') einen Rücksetzschritt zum Entladen der kapazitiven Elemente (C1, C2, C3), Vorspannen des ersten Eingangs (e1_ao) des Operationsverstärkers auf die zweite Referenzspannung (VREFO) und Einstellen der ersten Referenzspannung (VREF1, VREF2, VREF3) auf die maximale Amplitude unter den N vorbestimmten Amplituden;
ii') einen Leseschritt einer ersten Eingangsspeicherzelle (CM₁), indem ihr Auswahltransistor (T1) in den leitenden Zustand versetzt wird und ein Lesesteuersignal (VSL) an ihren ersten Eingangs-/Ausgangsknoten (SL) mit einer Amplitude angelegt wird, die im Wesentlichen gleich der zweiten Referenzspannung (VREFO) ist, um einen Ladungstransfer vom elementaren Speicherelement (NVM) der ausgewählten Speicherzelle an sein zugeordnetes kapazitives Element (C1) zu bewirken;
iii') Wiederholen des Schrittes ii') für die N Eingangsspeicherzellen (CM₂, CM₃);
iv') einen Einstellschritt der ersten Referenzspannung (VREF_cmp) auf einen vorbestimmten Wert, je nach Art der logischen Operation, unter den N Amplituden, um ein digitales Ausgangssignal (Vs1_cmp) zu erzeugen, das dem Ergebnis der logischen Operation entspricht.

10. Datenspeicherschaltung (1) nach einem der Ansprüche 5 bis 9, wobei die Ablaufsteuerungsschaltung (33) so konfiguriert ist, dass sie nach dem Lesen eines dem zweiten logischen Zustand ("1") entsprechenden Datenelements in einer ausgewählten Speicherzelle ein Steuersignal (VSL) an den ersten Eingangs-/Ausgangsknoten (SL) der ausgewählten Speicherzelle anlegt, mit einer Amplitude unterhalb der zweiten Referenzspannung (VREF0), und den Auswahltransistor (T1) der ausgewählten Speicherzelle in einem leitenden Zustand hält, um in seinem elementaren Speicherkomponenten (NVM) einen Ladungspegel zurückzusetzen, der dem zweiten logischen Zustand ("1") entspricht.

11. Datenspeicherschaltung (1) nach einem der Ansprüche 2 bis 10, wobei der erste logische Zustand ("0") einem nicht geladenen Zustand einer elementaren Speicherkomponente (NVM) entspricht, und wobei die Ablaufsteuerungsschaltung (33) so beschaffen ist, dass, nach dem Lesen eines Datenelements, das einem ersten logischen Zustand ("0") entspricht, die Ablaufsteuerungsschaltung (33) so konfiguriert ist, dass sie den Auswahltransistor (T1) der ausgewählten Speicherzelle nichtleitend macht, bevor sie das Steuersignal (VSL) am ersten Eingangs-/Ausgangsknoten (SL) auf einen neuen Wert ändert, um die soeben gelesene Speicherzelle in einem nicht geladenen Zustand zu halten.

12. Datenspeicherschaltung (1) nach einem der Ansprüche 5 bis 11, wobei die elementare Speicherkomponente (NVM) einer Eingangsspeicherzelle (CM₁, CM₂, CM₃) vom Typ FeRAM oder vom Typ ferroelektrischer Tunnelübergang FTJ ist.

13. Datenspeicherschaltung (1) nach einem der Ansprüche 1 bis 4, wobei, wenn die Rückkopplungsimpedanz (CCR) eine Widerstandsimpedanz ist und die elementaren Speicherkomponenten (NVM) der Eingangsspeicherzellen (CM₁, CM₂, CM₃) vom Typ Widerstand mit variablem leitendem Filament sind, die logische Verarbeitungsschaltung (3) so konfiguriert ist, dass sie eine logische Operation durchführt, indem sie die folgenden Schritte ausführt:
a) einen Rücksetzschritt zum Vorspannen des ersten Eingangs (e1_ao) des Operationsverstärkers auf die zweite Referenzspannung (VREFO) und Einstellen der ersten Referenzspannung (VREF_cmp) auf die maximale Amplitude (VREF1) unter den N vorbestimmten Amplituden;
b) einen Leseschritt der Eingangsspeicherzellen (CM₁, CM₂, CM₃), indem ihre Auswahltransistoren (T1) parallel oder sequentiell in den leitenden Zustand versetzt werden, und ein positives Lesesteuersignal (VSL) an ihre ersten Eingangs-/Ausgangsknoten (SL) angelegt wird;
c) einen Einstellschritt der ersten Referenzspannung (VREF_cmp) auf einen vorbestimmten Wert, je nach Art der logischen Operation, unter den N Amplituden, durch die Steuereinheit (33), um ein digitales Ausgangssignal (Vs1_cmp) zu erzeugen, das dem Ergebnis der logischen Operation entspricht.

14. Datenspeicherschaltung (1) nach einem der Ansprüche 7 oder 9 oder 13, wobei in dem Einstellschritt der ersten Referenzspannung (VREF_cmp), je nach Art der logischen Operation:
die Steuereinheit (33) so konfiguriert ist, dass sie die erste Referenzspannung (VREF_cmp) auf die minimale Amplitude (VREF3) unter den N vorbestimmten Amplituden einstellt, wenn es die logische Operation vom Typ UND ist.

15. Datenspeicherschaltung (1) nach einem der Ansprüche 7 oder 9 oder 13, wobei in dem Einstellschritt der ersten Referenzspannung (VREF_cmp), je nach Art der logischen Operation:
die Steuereinheit (33) so konfiguriert ist, dass sie die erste Referenzspannung (VREF_cmp) auf die maximale Amplitude (VREF1) unter den N vorbestimmten Amplitude einstellt, wenn die logische Operation vom Typ ODER ist.

## Claims

1. A data storage circuit (1) comprising:
- an array (2) of memory cells (CMᵢⱼ) such that each memory cell (CMᵢⱼ) comprises:
• a non-volatile elementary storage component (NVM) having a first electrode (EL1) and a second electrode (EL2);
• a first input/output node (SL) connected to the second electrode (EL2), a second input/output node (BL), a selection node (WL);
• and a selection transistor (T1) having a gate connected to the selection node (WL) and linking the first electrode (EL1) to the second input/output node (BL);
- a logic processing circuit (3) configured to carry out a logic operation having N binary data (x1, x2, x3) as operands stored in N input memory cells (CM₁, CM₂, CM₃), with N ≥ 2; the second input/output nodes (BL) of said input memory cells (CM₁, CM₂, CM₃) being linked by a common bit line; the logic processing circuit (3) comprising:
• a transimpedance amplifier stage (31) configured to supply an analogue read signal (Vs1_ao) from the voltage of the common bit line (BL); the capacitive transimpedance amplifier stage (31) comprising:
∘ an operational amplifier (AO) having: a first input (e1_ao) connected to the second input/output node (BL) of the input memory cells, and a second input (e2_ao) for receiving a second reference voltage (VREF0); and an output (s1_ao) for supplying said analogue read signal (Vs1_ao);
∘ a feedback impedance (CCR) mounted between the output (s1_ao) and the first input (e1_ao) of the operational amplifier;
• a comparator (32) intended to compare the analogue read signal (Vs1_ao) with a first adjustable reference voltage (VREF_cmp) to generate a digital output signal (Vs1_cmp) corresponding to the result of the logic operation;
• a control unit (34) configured to adjust the reference voltage (VREF_cmp) to an amplitude selected from among N distinct predetermined amplitudes (VREF1, VREF2, VREF3), depending on the type of the logic operation;
the feedback impedance (CCR) being a capacitive impedance and the elementary storage components (NVM) of the input memory cells (CM₁, CM₂, CM₃) being of the variable electric biasing ferroelectric type; or
the feedback impedance (CCR) being a resistive impedance and the elementary storage components (NVM) of the input memory cells (CM₁, CM₂, CM₃) being of the variable conductive filament resistive type.

2. The data storage circuit (1) according to claim 1, further comprising a sequencer (33) configured to apply:
- a write and read control signal (VSL) to the first input/output node (SL) of each of the input memory cells (CM₁, CM₂, CM₃);
- a selection signal (VWL1, VWL2, VWL3) to the selection node (WL) of each of the input memory cells (CM₁, CM₂, CM₃).

3. The data storage circuit (1) according to any one of claim 1 or 2, wherein the first input/output nodes (SL) of said input memory cells (CM₁, CM₂, CM₃) are linked by a common source line.

4. The data storage circuit (1) according to any one of claims 1 to 3, wherein the logic processing circuit (3) further comprises a reset switch (i1) mounted between the output (s1_ao) and the first input (e1_ao) of the operational amplifier.

5. The data storage circuit (1) according to any one of claims 1 to 4, wherein:
when the feedback impedance (CCR) is a capacitive impedance and when the elementary storage components (NVM) of the input memory cells (CM₁, CM₂, CM₃) are of the variable electric biasing ferroelectric type, each memory cell can have a first ("0") or a second ("1") logic state respectively corresponding to different levels of charges stored in the associated elementary storage component (NVM).

6. The data storage circuit (1) according to claim 5, wherein each elementary storage component (NVM) of the input memory cells (CM₁, CM₂, CM₃) has a first predetermined capacitance, and wherein the feedback impedance (CCR) is a capacitive element (C1) having a second capacitance that is more than N times said first predetermined capacitance.

7. The data storage circuit (1) according to claim 6, wherein the N predetermined amplitudes (VREF1, VREF2, VREF3) are ordered in descending order, and wherein the logic processing circuit (3) is configured to carry out a logic operation by executing the following steps:
i) a step of resetting for discharging the capacitive element (C1), biasing the first input (e1_ao) of the operational amplifier to the second reference voltage (VREFO) and adjusting the first reference voltage (VREF_cmp) to the maximum amplitude from among the N predetermined amplitudes (VREF1);
ii) a step of reading a first input memory cell (CM₁) by setting its selection transistor (T1) to the on-state and applying a read control signal (VSL) to its first input/output node (SL) having an amplitude substantially equal to the second reference voltage (VREFO) so as to cause a transfer of charges from the elementary storage component (NVM) of the selected memory cell to its associated capacitive element (C1).
iii) a step of adjusting, by the control unit (33), the first reference voltage (VREF_cmp) by adjusting the amplitude of the first reference voltage to amplitude of the next order (VREF2) from among the N predetermined amplitudes when the binary piece of data read in the previous step is a high logic state;
iv) repeating steps ii) and iii) for the N input memory cells (CM₂, CM₃);
v) a step of adjusting, by the control unit (33), the first reference voltage (VREF_cmp) to a predetermined value, according to the type of the logic operation, from among the N amplitudes to generate a digital output signal (Vs1_cmp) corresponding to the result of the logic operation.

8. The data storage circuit (1) according to claim 5, wherein each elementary storage component (NVM) of the input memory cells (CM₁, CM₂, CM₃) has a first predetermined capacitance, and wherein the feedback impedance (CCR) is produced by N capacitive elements (C1, C2, C3) mounted in parallel, with each capacitive element (C1, C2, C3) being associated with an input memory cell (CM₁, CM₂, CM₃) and having a second capacitance greater than or equal to said first predetermined capacitance.

9. The data storage circuit (1) according to claim 8, wherein the logic processing circuit (3) is configured to carry out a logic operation by executing the following steps:
i') a step of resetting for discharging the capacitive elements (C1, C2, C3), biasing the first input (e1_ao) of the operational amplifier to the second reference voltage (VREFO) and adjusting the first reference voltage (VREF1, VREF2, VREF3) to the maximum amplitude from among the N predetermined amplitudes;
ii') a step of reading a first input memory cell (CM₁) by setting its selection transistor (T1) to the on-state and applying a read control signal (VSL) to its first input/output node (SL) having an amplitude substantially equal to the second reference voltage (VREFO) so as to cause a transfer of charges from the elementary storage component (NVM) of the selected memory cell to its associated capacitive element (C1);
iii') repeating step ii') for the N input memory cells (CM₂, CM₃);
iv') a step of adjusting the first reference voltage (VREF_cmp) to a predetermined value, according to the type of the logic operation, from among the N amplitudes to generate a digital output signal (Vs1_cmp) corresponding to the result of the logic operation.

10. The data storage circuit (1) according to any one of claims 5 to 9, wherein the sequencer circuit (33) is configured to apply, after reading a piece of data corresponding to the second logic state ("1") in a selected memory cell, a control signal (VSL) to the first input/output node (SL) of said selected memory cell, having an amplitude below the second reference voltage (VREFO) and keeping the selection transistor (T1) of the selected memory cell in an on-state so as to restore, in its elementary storage component (NVM), a charge level corresponding to the second logic state ("1").

11. The data storage circuit (1) according to any one of claims 2 to 10, wherein said first logic state ("0") corresponds to an uncharged state of an elementary storage component (NVM), and wherein said sequencer circuit (33) is such that, after reading a piece of data corresponding to a first logic state ("0"), said sequencer circuit (33) is configured to make said selection transistor (T1) of the selected memory cell nonconductive before changing the control signal (VSL) on the first input/output node (SL) to a new value, to keep the memory cell that has just been read in an uncharged state.

12. The data storage circuit (1) according to any one of claims 5 to 11, wherein the elementary storage component (NVM) of an input memory cell (CM₁, CM₂, CM₃) is of the FeRAM type or of the ferroelectric tunnel junction (FTJ) type.

13. The data storage circuit (1) according to any one of claims 1 to 4, wherein, when the feedback impedance (CCR) is a resistive impedance and wherein the elementary storage components (NVM) of the input memory cells (CM₁, CM₂, CM₃) are of the variable conductive filament resistive type, the logic processing circuit (3) is configured to carry out a logic operation by executing the following steps:
a) a step of resetting for biasing the first input (e1_ao) of the operational amplifier to the second reference voltage (VREFO) and adjusting the first reference voltage (VREF_cmp) to the maximum amplitude (VREF1) from among the N predetermined amplitudes;
b) a step of reading the input memory cells (CM₁, CM₂, CM₃), by setting their selection transistors (T1) to the on-state simultaneously or sequentially, and by applying a positive read control signal (VSL) to their first input/output nodes (SL);
c) a step of adjusting, by the control unit (33), the first reference voltage (VREF_cmp) to a predetermined value, according to the type of the logic operation, from among the N amplitudes, to generate a digital output signal (Vs1_cmp) corresponding to the result of the logic operation.

14. The data storage circuit (1) according to any one of claims 7 or 9 or 13, wherein, during the step of adjusting the first reference voltage (VREF_cmp) according to the type of the logic operation,
the control unit (33) is configured to adjust the first reference voltage (VREF_cmp) to the maximum amplitude (VREF3) from among the N predetermined amplitudes when the logic operation is of the AND type.

15. The data storage circuit (1) according to any one of claims 7 or 9 or 13, wherein, during the step of adjusting the first reference voltage (VREF_cmp) according to the type of the logic operation,
the control unit (33) is configured to adjust the first reference voltage (VREF_cmp) to the maximum amplitude (VREF1) from among the N predetermined amplitudes when the logic operation is of the OR type.
